# EUROPEAN PATENT APPLICATION

(11) **EP 4 503 894 A1**
(43) Date of publication of application: **05.02.2025**
(21) Application number: 24192527.0
(22) Date of filing: 02.08.2024
(51) Int. Cl.: H10K 59/121, H10K 59/122, H10K 59/35

(54) **DISPLAY DEVICE**

(30) Priority: 04.08.2023 KR 20230102348
(71) Applicant: Samsung Display Co., Ltd., Gyeonggi-do 17113 (KR)
(72) Inventor: JIN, Guanghai, 17113 Yongin-si (KR)
(74) Representative: Marks & Clerk LLP

(57) **Abstract**

A display device includes: a first light emitting element disposed in a first pixel area on a substrate and including a first pixel electrode having an octagonal planar shape, a second light emitting element disposed in a second pixel area on the substrate and including a second pixel electrode, a third emitting element disposed in a third pixel area on the substrate and including a third pixel electrode having an octagonal planar shape, and a pixel defining layer covering edges of each of the first, second, and third pixel electrodes. A virtual line extending to coincide with sides of the first pixel electrode defines a virtual first quadrangle and a virtual line extending to coincide with sides of the third pixel electrode adjacent to the first pixel electrode defines a virtual second quadrangle. The virtual first quadrangle at least partially overlaps the virtual second quadrangle in a plan view.

## Description

### BACKGROUND

### 1. Technical Field

Embodiments are generally related to a display device. More particularly, embodiments relate to a display device which provides visual information.

### 2. Description of the Related Art

As information technology develops, the importance of display devices, which are communication media between users and information, is being highlighted. Accordingly, the use of display devices such as a liquid crystal display device, an organic light emitting display device, a plasma display device, and the like is increasing.

Meanwhile, the display device may include a plurality of pixels, and each of the plurality of pixels may include at least one transistor and an organic light emitting element electrically connected to the at least one transistor.

For example, techniques for depositing a light emitting layer included in an organic light emitting element on a substrate may include a process using a fine metal mask (FMM), a photo lithography process without using the fine metal mask, or the like.

### SUMMARY

Embodiments provide a display device that can prevent luminous efficiency from being reduced.

A display device according to embodiments of the present disclosure includes a substrate including a first pixel area, a second pixel area, and a third pixel area which emit light of different colors, a first light emitting element disposed in the first pixel area on the substrate and including a first pixel electrode having an octagonal planar shape, a second light emitting element disposed in the second pixel area on the substrate and including a second pixel electrode, a third emitting element disposed in the third pixel area on the substrate and including a third pixel electrode having an octagonal planar shape, and a pixel defining layer covering edges of the first, second, and third pixel electrodes and defining first, second, and third pixel openings exposing at least a part of each of the first, second, and third pixel electrodes, respectively. A virtual first line extending to coincide with each of first sides extending in a first direction of the first pixel electrode and a virtual second line extending to coincide with each of second sides extending in a second direction perpendicular to the first direction of the first pixel electrode define a virtual first quadrangle. A virtual third line extending to coincide with each of first sides extending in the first direction of the third pixel electrode adjacent to the first pixel electrode and a virtual fourth line extending to coincide with each of second sides extending in the second direction of the third pixel electrode define a virtual second quadrangle. The virtual first quadrangle at least partially overlaps the virtual second quadrangle in a plan view.

In an embodiment, the second pixel electrode may have a rectangular, circular, or octagonal planar shape.

In an embodiment, the first pixel area may emit red light, the second pixel area may emit green light, and the third pixel area may emit blue light.

In an embodiment, a length of a side of the first pixel electrode extending parallel to a first side of the second pixel electrode may be shorter than a length of a side of the third pixel electrode extending parallel to a second side of the second pixel electrode.

In an embodiment, a length of a third side of the first pixel electrode which connects the first side and the second side of the first pixel electrode may be a same as a length of a third side of the third pixel electrode which connects the first side and the second side of the third pixel electrode and extends parallel to the third side of the first pixel electrode.

In an embodiment, a length of a first side of the second pixel electrode extending parallel to the second side of the first pixel electrode may be the same as a length of the second side of the first pixel electrode. A length of a second side of the second pixel electrode extending parallel to the first side of the third pixel electrode is the same as a length of the first side of the third pixel electrode.

In an embodiment, a planar shape of the first pixel opening may substantially correspond to a planar shape of the first pixel electrode, a planar shape of the second pixel opening may substantially correspond to a planar shape of the second pixel electrode, and a planar shape of the third pixel opening may substantially correspond to a planar shape of the third pixel electrode.

In an embodiment, the first light emitting element may further include a first light emitting layer disposed in the first pixel opening, the second light emitting element may further include a second light emitting layer disposed in the second pixel opening, and the third light emitting element may further include a third light emitting layer disposed in the third pixel opening.

In an embodiment, the display device may further include a first transistor connected to the first pixel electrode through a first contact hole, a second transistor connected to the second pixel electrode through a second contact hole, and a third transistor connected to the third pixel electrode through a third contact hole.

In an embodiment, each of the first, second, and third contact holes may have a rectangular planar shape.

In an embodiment, the first contact hole may not overlap with the first light emitting layer in the plan view, the second contact hole may not overlap with the second light emitting layer in the plan view, and the third contact hole may not overlap with the third light emitting layer in the plan view.

In an embodiment, at least one contact hole among the first, second, and third contact holes may be positioned at an edge of a pixel electrode adjacent to the at least one contact hole among the first, second, and third pixel electrodes.

In an embodiment, at least one pixel electrode among the first, second, and third pixel electrodes may include a protrusion positioned in one side, and at least one contact hole disposed adjacent to the at least one pixel electrode among the first, second, and third contact holes may partially overlap the protrusion in the plan view.

In an embodiment, at least one contact hole among the first, second, and third contact holes may be positioned at a center of a pixel electrode adjacent to the at least one contact hole among the first, second, and third pixel electrodes.

In an embodiment, the at least one contact hole may overlap the pixel defining layer in the plan view.

In an embodiment, the display device may further include a conductive pattern filling each of the first, second, and third contact holes, contacting each of the first, second, and third pixel electrodes, and includes a conductive material different from the first, second, and third pixel electrodes.

In an embodiment, the first, second, and third contact holes may at least partially overlap the first, second, and third light emitting layers in the plan view, respectively.

In an embodiment, a size of the first pixel electrode may be substantially a same as a size of the third pixel electrode.

In an embodiment, each side of the first pixel electrode facing the second pixel electrode may be depressed toward a center of the first pixel electrode and each side of the third pixel electrode facing the second pixel electrode may be depressed toward a center of the third pixel electrode. The second pixel electrode may have an octagonal or circular planar shape.

In an embodiment, each side of the third pixel electrode facing the second pixel electrode may be depressed toward a center of the third pixel electrode, and the second pixel electrode may have an octagonal or circular planar shape.

In an embodiment, a virtual line extending in a third direction between the first direction and the second direction, and a fourth direction perpendicular to the third direction may define a virtual square. Centers of first pixel electrodes may be positioned at first vertices of the virtual square facing each other, centers of third pixel electrodes may be positioned at second vertices of the virtual square facing each other, and the second pixel electrode may be positioned at a center of the virtual square.

A display device according to embodiments of the present disclosure includes a substrate including a first pixel area, a second pixel area, and a third pixel area which emit light of different colors, a first light emitting element disposed in the first pixel area on the substrate and including a first pixel electrode having a polygonal planar shape, a second light emitting element disposed in the second pixel area on the substrate and including a second pixel electrode, a third emitting element disposed in the third pixel area on the substrate and including a third pixel electrode having a polygonal planar shape, and a pixel defining layer covering edges of each of the first, second, and third pixel electrodes and defining first, second, and third pixel openings exposing at least a part of each of the first, second, and third pixel electrodes, respectively. Any one of the first and third pixel electrodes may have a quadrangle planar shape including a chamfered corner part.

In an embodiment, another of the first and third pixel electrodes may have a quadrangle or octagonal planar shape.

In an embodiment, a virtual first line extending to coincide with each of first sides extending in a first direction of the any one of the first and third pixel electrodes and a virtual second line extending to coincide with each of second sides extending in a second direction perpendicular to the first direction of the any one of the first and third pixel electrodes may define a virtual quadrangle. The virtual quadrangle may at least partially overlap the another of the first and third pixel electrode in the plan view.

In an embodiment, when the first pixel electrode includes the chamfered corner part and the third pixel electrode has a quadrangle planar shape, the chamfered corner part of the first pixel electrode may surround at least a part of corner part of the third pixel electrode facing each other in the plan view.

In an embodiment, the second pixel electrode may have a quadrangle planar shape.

In an embodiment, at least one pixel electrode among the first, second, and third pixel electrodes may include a protrusion positioned in one side, and at least one contact hole adjacent to the at least one pixel electrode among the first, second, and third contact holes may partially overlap the protrusion in the plan view.

In an embodiment, at least one contact hole among the first, second, and third contact holes may be positioned at a center of a pixel electrode adjacent to the at least one contact hole among the first, second, and third pixel electrodes.

In an embodiment, the display device may further include a first transistor connected to the first pixel electrode through a first contact hole, a second transistor connected to the second pixel electrode through a second contact hole, and a third transistor connected to the third pixel electrode through a third contact hole.

In an embodiment, at least one contact hole among the first, second, and third contact holes may be positioned at an edge of a pixel electrode adjacent to the at least one contact hole among the first, second, and third pixel electrodes.

At least some of the above and other features of the invention are set out in the claims.

In a display device according to an embodiment of the present disclosure, each of a first pixel electrode disposed in a first pixel area which emits red light and a third pixel electrode disposed in a third pixel area which emits blue light may have an octagonal planar shape, and a second pixel electrode disposed in a second pixel area which emits green light may have a quadrangle planar shape. A first virtual quadrangle defined by a virtual line extending to coincide with sides extending in a diagonal direction of the first pixel electrode may at least partially overlap a second virtual quadrangle defined by a virtual line extending to coincide with sides extending in a diagonal direction of the third pixel electrode. Accordingly, the luminous efficiency of the display device can be prevented from being reduced.

Alternatively, in a display device according to an embodiment of the present disclosure, any one of the first and third pixel electrodes may have a quadrangle planar shape including a chamfered corner part, and another of the first and third pixel electrodes may have a quadrangle or octagonal planar shape. Accordingly, the luminous efficiency of the display device can be prevented from being reduced.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to an embodiment of the present disclosure.
FIG. 2 is an enlarged plan view illustrating an example of a part of the display area of FIG. 1.
FIG. 3 is a plan view for explaining first, second, and third pixel electrodes of FIG. 2.
FIG. 4 is a plan view for explaining a relationship between a first pixel electrode, a first pixel opening, and a first contact hole, and a relationship between a second pixel electrode, a second pixel opening, and a second contact hole in FIG. 2.
FIG. 5 is a plan view for explaining a relationship between a third pixel electrode, a third pixel opening, and a third contact hole of FIG. 2.
FIG. 6 is a cross-sectional view taken along line I-I' of FIG. 2.
FIGS. 7 and 8 are plan views illustrating examples of a first contact hole, a second contact hole, and a third contact hole of FIG. 2.
FIG. 9 is an enlarged plan view of another example of a part of the display area of FIG. 1.
FIG. 10 is a cross-sectional view taken along line II-II' of FIG. 9.
FIG. 11 is a plan view illustrating an example of a first contact hole, a second contact hole, and a third contact hole of FIG. 9.
FIGS. 12, 13, 14, 15, 16, 17, and 18 are plan views illustrating examples of the planar shape of each of first, second, and third pixel electrodes of FIGS. 2 and 9.

### DETAILED DESCRIPTION OF THE EMBODIMENTS

Hereinafter, a display device according to embodiments of the present disclosure will be explained in detail with reference to the accompanying drawings. The same reference numerals are used for the same components in the drawings, and redundant descriptions of the same components will be omitted.

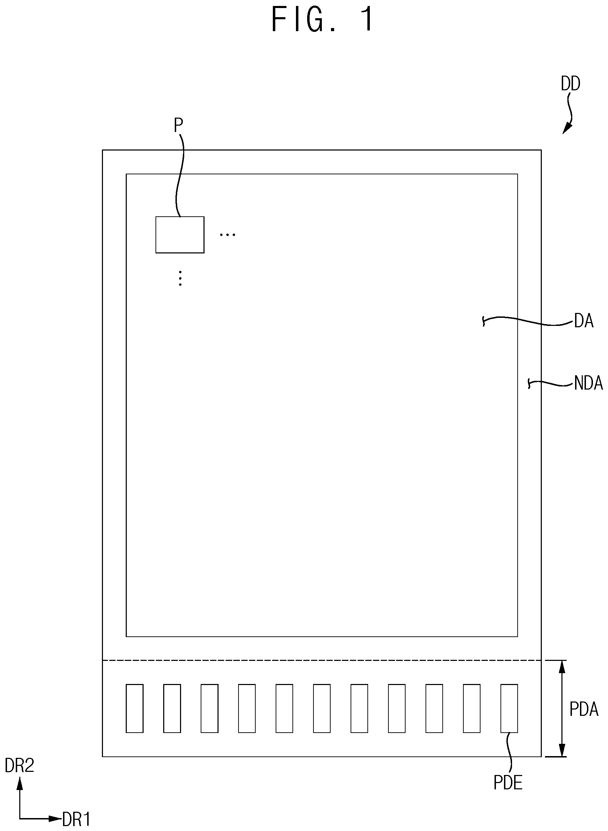

FIG. 1 is a plan view illustrating a display device according to an embodiment of the present disclosure.

Referring to FIG. 1, a display device DD according to an embodiment of the present disclosure may include a display area DA and a non-display area NDA. The display area DA may be an area that can display an image by generating light or adjusting the transmittance of light provided from an external light source. The non-display area NDA may be an area that does not display images. The non-display area NDA may be positioned around the display area DA. For example, the non-display area NDA may entirely surround the display area DA.

A plurality of pixels P may be arranged in the display area DA. The plurality of pixels P may be arranged in a matrix form along a first direction DR1 and a second direction DR2 crossing the first direction DR1.

Each of the plurality of pixels P may include at least one transistor which generates a driving current and an organic light emitting element electrically connected to the transistor and which receives the driving current. The organic light emitting element may emit light based on the driving current. As each of the plurality of pixels P emits light through the organic light emitting element, the display area DA may display an image.

One pixel P may display one predetermined basic color. In other words, one pixel P may be the smallest unit capable of displaying a color independent of other pixels P. For example, one pixel P may display any one color among red, green, and blue.

The non-display area NDA may include a pad area PDA. The pad area PDA may be positioned away from one side of the display area DA. For example, the pad area PDA may have a shape extending in the first direction DR1.

A plurality of signal lines may be disposed in the non-display area NDA, and a plurality of pad electrodes PDE may be disposed in the pad area PDA. The signal lines may electrically connect the pad electrodes PDE and the plurality of pixels P. For example, the signal lines may include data signal lines, scan signal lines, emission control signal lines, power voltage lines, and the like.

The pad electrodes PDE may be disposed to be spaced apart from each other in the first direction DR1. For example, each of the pad electrodes PDE may include metal, alloy, metal nitride, conductive metal oxide, transparent conductive material, and the like. These can be used alone or in combination with each other.

In this specification, a plane may be defined as the first direction DR1 and the second direction DR2 that intersects the first direction DR1. For example, the first direction DR1 may be perpendicular to the second direction DR2.

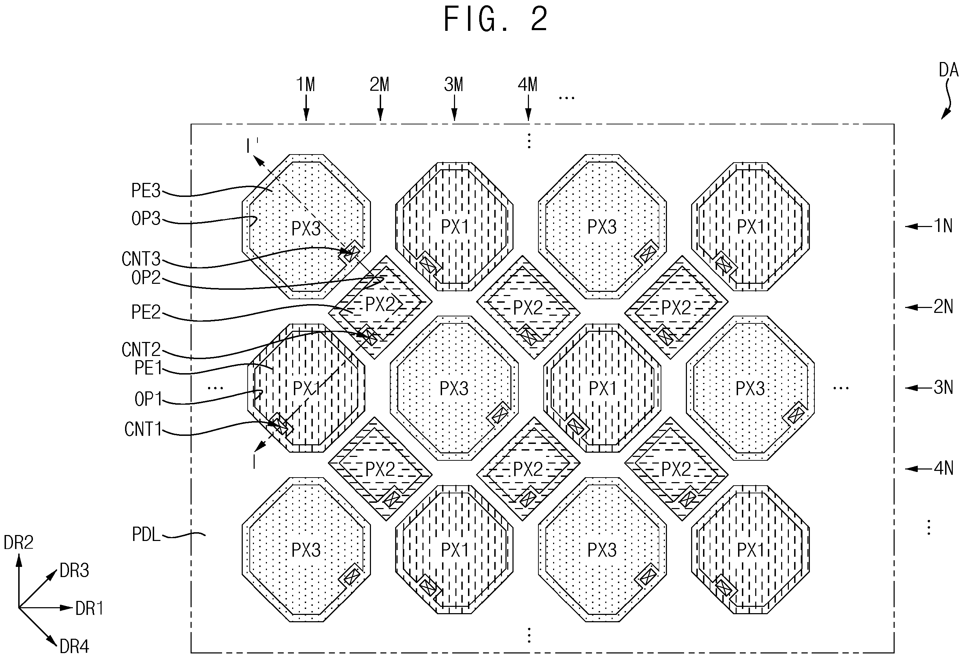

FIG. 2 is an enlarged plan view illustrating an example of a part of the display area of FIG. 1.

Referring to FIG. 2, the display area DA may include first pixel areas PX1, second pixel areas PX2, and third pixel areas PX3. The plurality of pixels P shown in FIG. 1 may be disposed in the first, second, and third pixel areas PX1, PX2, and PX3, respectively.

Each of the first pixel areas PX1, the second pixel areas PX2, and the third pixel areas PX3 may represents an area where light emitted from the organic light emitting element is emitted to the outside of the display device DD. For example, the first pixel areas PX1 may emit first light, the second pixel areas PX2 may emit second light, and the third pixel areas PX3 may emit third light. In an embodiment, the first light may be red light, the second light may be green light, and the third light may be blue light. However, the present disclosure is not limited to this. For example, the first, second, and third pixel areas PX1, PX2, and PX3 may be combined to emit yellow, cyan, and magenta lights.

The first, second, and third pixel areas PX1, PX2, and PX3 may emit light of four or more colors. For example, the first, second, and third pixel areas PX1, PX2, and PX3 may be combined to emit at least one of yellow, cyan, and magenta lights in addition to red, green, and blue lights. In addition, the first, second, and third pixel areas PX1, PX2, and PX3 may be combined to emit white light.

The first, second, and third pixel areas PX1, PX2, and PX3 may be arranged in a matrix form along the first direction DR1 and the second direction DR2. In an embodiment, the first, second, and third pixel areas PX1, PX2, and PX3 may be arranged in a diamond pentile^{™} shape. For example, the third pixel areas PX3 and the first pixel areas PX1 may be alternately arranged in a first row 1N, and, the second pixel areas PX2 may be arranged at a predetermined interval in a second row 2N adjacent to the first row 1N. In addition, the first pixel areas PX1 and the third pixel areas PX3 may be alternately arranged in a third row 3N adjacent to the second row 2N, and the second pixel areas PX2 may be arranged at a predetermined interval in a fourth row 4N adjacent to the third row 3N. The arrangement of these pixel areas may be repeated up to the Nth row (where N is a natural number).

The second pixel areas PX2 arranged in the second row 2N may be disposed adjacent to the first pixel areas PX1 arranged in the first row 1N and the third row 3N in a third direction DR3 or a fourth direction DR4, and may be disposed adjacent to the third pixel areas PX3 arranged in the first row 1N and the third row 3N in the third direction DR3 or the fourth direction DR4. Accordingly, the third pixel areas PX3 and the first pixel areas PX1 may be alternately arranged in a first column 1M, and the second pixel areas PX2 may be arranged at a predetermined interval in a second column 2M disposed adjacent to the first column 1M. In addition, the first pixel areas PX1 and third pixel areas PX3 may be alternately arranged in a third row 3M disposed adjacent to the second row 2M, and the second pixel areas PX2 may be arranged at a predetermined interval in a fourth column 4M disposed adjacent to the third column 3M. The arrangement of these pixel areas may be repeated up to the Mth column (where M is a natural number).

Here, the third direction DR3 may be a direction between the first direction DR1 and the second direction DR2, and the fourth direction DR4 may be perpendicular to the third direction DR3.

A first pixel electrode PE1 may be disposed in each of the first pixel areas PX1, a second pixel electrode PE2 may be disposed in each of the second pixel areas PX2, and a third pixel electrode PE3 may be disposed in each of the third pixel areas PX3. The first, second, and third pixel electrodes PE1, PE2, and PE3 may be disposed to be spaced apart from each other.

Each of the first, second, and third pixel electrodes PE1, PE2, and PE3 may have various polygonal planar shapes. In an embodiment, each of the first and third pixel electrodes PE1 and PE3 may have an octagonal planar shape, and the second pixel electrode PE2 may have a quadrangle (e.g., rectangle) planar shape. In this case, each corner of the rectangle may have a right angle or be rounded at a predetermined curvature. However, embodiments of the present disclosure are not limited thereto. A detailed description of the planar shape of each of the first, second, and third pixel electrodes PE1, PE2, and PE3 will be described later.

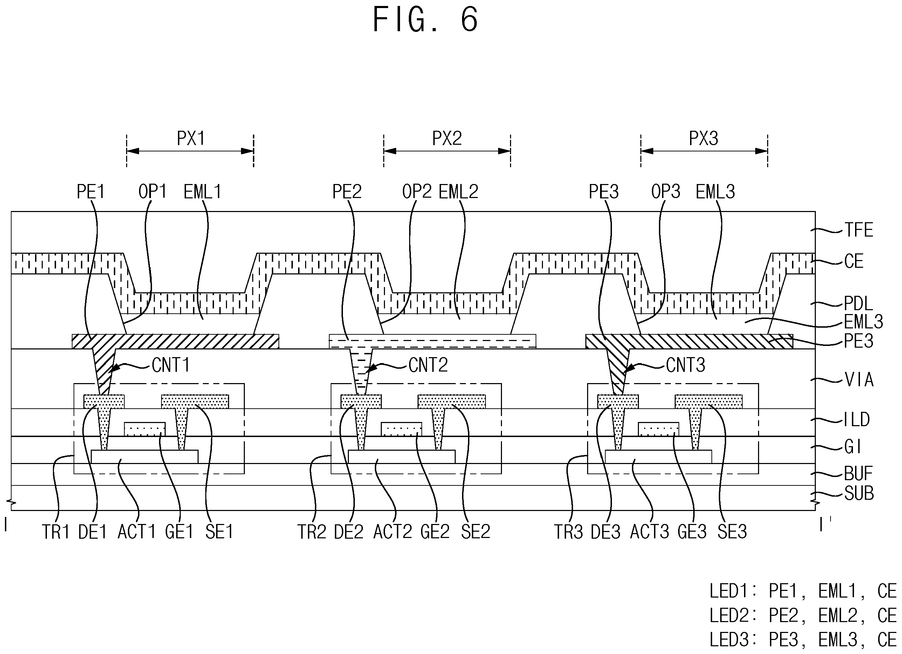

The first pixel electrode PE1 may be electrically connected to a first transistor (e.g., a first transistor TR1 of FIG. 6) through a first contact hole CNT1, the second pixel electrode PE2 may be electrically connected to a second transistor (e.g., a second transistor TR2 of FIG. 6) through a second contact hole CNT2, and the third pixel electrode PE3 may be electrically connected to a third transistor (e.g., a third transistor TR3 of FIG. 6) through a third contact hole CNT3.

At least one contact hole among the first, second, and third contact holes CNT1, CNT2, and CNT3 may be positioned at an edge of a pixel electrode disposed adjacent to the at least one contact hole among the first, second, and third pixel electrodes PE1, PE2, and PE3. In an embodiment, the first, second, and third contact holes CNT1, CNT2, and CNT3 may be positioned at the edges of the first, second, and third pixel electrodes PE1, PE2, and PE3, respectively. In this case, for example, each of the first, second, and third pixel electrodes PE1, PE2, and PE3 may not include a protrusion positioned in one side. That is, each of the first and third pixel electrodes PE1 and PE3 may have a completely octagonal planar shape which does not include the protrusion, and the second pixel electrode PE2 may have a completely quadrangle planar shape which does not include the protrusion.

Each of the first, second, and third contact holes CNT1, CNT2, and CNT3 may have a polygonal planar shape. In an embodiment, each of the first, second, and third contact holes CNT1, CNT2, and CNT3 may have a rectangular or elliptical planar shape. In this case, the rectangular planar shape may include corners each having a right angle or a rounded corner.

A pixel defining layer PDL may be disposed in the display area DA. Specifically, the pixel defining layer PDL may be disposed to cover the edges of each of the first, second, and third pixel electrodes PE1, PE2, and PE3.

The pixel defining layer PDL may define a first pixel opening OP1 exposing at least a part of the first pixel electrode PE1 in the first pixel area PX1, a second pixel opening OP2 exposing at least a part of the second pixel electrode PE2 in the second pixel area PX2, and a third pixel opening OP3 exposing at least a part of the third pixel electrode PE3 in the third pixel area PX3. For example, the pixel defining layer PDL may include an inorganic insulating material and/or an organic insulating material. Alternatively, the pixel defining layer PDL may include an inorganic insulating material and/or an organic insulating material containing a light blocking material.

In an embodiment, the pixel defining layer PDL may overlap the first, second, and third contact holes CNT1, CNT2, and CNT3 in the plan view. That is, the pixel defining layer PDL may cover the first, second, and third contact holes CNT1, CNT2, and CNT3.

In an embodiment, a planar shape of the first pixel opening OP1 may substantially correspond to a planar shape of the first pixel electrode PE1, a planar shape of the second pixel opening OP2 may substantially correspond to a planar shape of the second pixel electrode PE2, and a planar shape of the third pixel opening OP3 may substantially correspond to a planar shape of the third pixel electrode PE3. That is, except for the periphery of the first, second, and third contact holes CNT1, CNT2, and CNT3, the sides of the first, second, and third pixel openings OP1, OP2, and OP3 may be parallel to sides of the first, second, and third pixel electrodes PE1, PE2, and PE, respectively. In other words, each of the first and third pixel openings OP1 and OP3 may have a substantially octagonal planar shape, and the second pixel opening OP2 may have a substantially quadrangle planar shape.

A first light emitting layer (e.g., a first light emitting layer EML1 of FIG. 6) may be disposed in the first pixel opening OP1, a second light emitting layer (e.g., a second light emitting layer EML2 of FIG. 6) may be disposed in the second pixel opening OP2, and a third light emitting layer (e.g., a third light emitting layer EML3 of FIG. 6) may be disposed in the third pixel opening OP3.

A size of the first pixel opening OP1 may be substantially the same as a size of the first pixel area PX1, a size of the second pixel opening OP2 may be substantially the same as the size of the second pixel area PX2, and a size of the third pixel opening OP3 may be substantially the same as the size of the third pixel area PX3. That is, the first, second, and third light emitting layers disposed in each of the first, second, and third pixel openings OP1, OP2, and OP3 may correspond to the first, second, and third pixel areas PX1, PX2, and PX3, respectively.

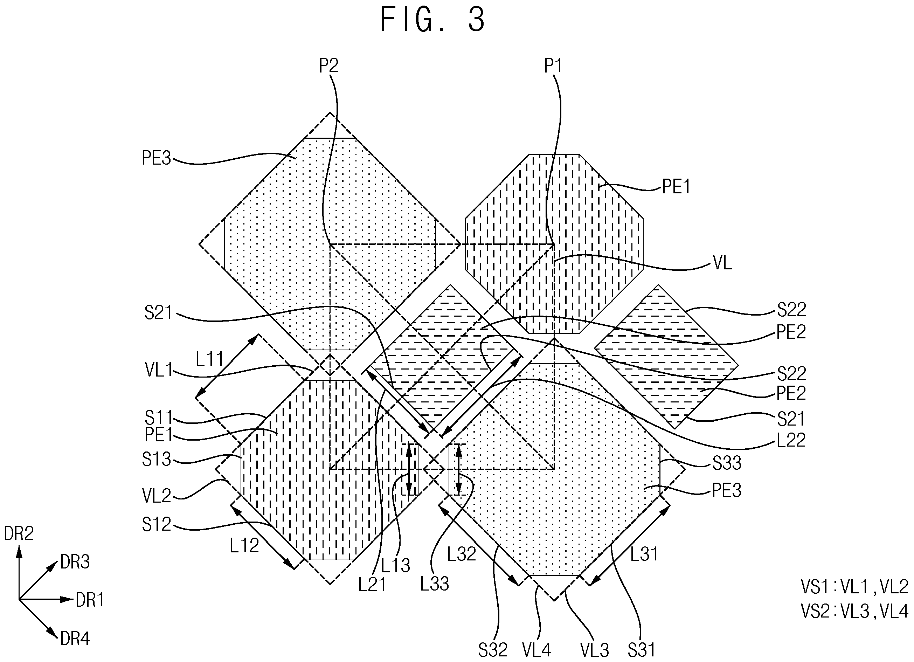

FIG. 3 is a plan view for explaining first, second, and third pixel electrodes of FIG. 2.

Referring to FIGS. 2 and 3, a size of the first pixel electrode PE1, a size of the second pixel electrode PE2, and a size of the third pixel electrode PE3 may be different from each other. In an embodiment, the size of the third pixel electrode PE3 may be larger than the size of the first pixel electrode PE1, and the size of the first pixel electrode PE1 may be larger than the size of the second pixel electrode PE2. However, embodiments of the present disclosure are not limited thereto.

As described above, the first pixel electrode PE1 may be disposed in the first pixel area PX1, the second pixel electrode PE2 may be disposed in the second pixel area PX2, and the third pixel electrode PE3 may be disposed in the third pixel area PX3. Accordingly, the arrangement of the first, second, and third pixel electrodes PE1, PE2, and PE3 may be substantially the same as the arrangement of the first, second, and third pixel areas PX1, PX2, and PX3.

In an embodiment, a virtual line VL extending in the first direction DR1 and the second direction DR2 may define a virtual square, centers of the first pixel electrodes PE1 may be positioned at first vertices P1 facing each other of the virtual square, centers of the third pixel electrodes PE3 may be positioned at second vertices P2 facing each other of the virtual square, and the second pixel electrode PE2 may be positioned at the center of the virtual square.

A virtual first line VL1 extending to coincide with each of first sides S11 extending in the third direction DR3 of the first pixel electrode PE1 and a virtual second line VL2 extending to coincide with each of second sides S12 extending in the fourth direction DR4 of the first pixel electrode PE1 define a first virtual quadrangle VS1 (e.g., square).

Likewise, a virtual third line VL3 extending to coincide with each of first sides S31 extending in the third direction DR3 of the third pixel electrode PE3 adjacent to the first pixel electrode PE1 and a virtual fourth line VL4 extending to coincide with each of second sides S32 extending in the fourth direction DR4 of the third pixel electrode PE3 define a virtual second quadrangle VS2 (e.g., square).

In an embodiment, the first virtual quadrangle VS1 partially overlaps the second virtual quadrangle VS2 in a plan view.

The first pixel electrode PE1 may include two first sides S11, two second sides S12, and four third sides S13. The first sides S11 of the first pixel electrode PE1 may face each other, the second sides S12 of the first pixel electrode PE1 may face each other, and the third sides S13 of the first pixel electrode PE1 disposed close to opposing corners of the virtual first quadrangle VS1 may face each other. Each of the first sides S11 of the first pixel electrode PE1 may extend in the third direction DR3, each of the second sides S12 may extend in the fourth direction DR4, and each of the third sides S13 may extend in the first direction DR1 or the second direction DR2.

Likewise, the third pixel electrode PE3 may include two first sides S31, two second sides S32, and four third sides S33. The first sides S31 of the third pixel electrode PE3 may face each other, the second sides S32 of the third pixel electrode PE3 may face each other, and the third sides S33 of the third pixel electrode PE3 disposed close to opposing corners of the virtual second quadrangle VS2 may face each other. Each of the first sides S31 of the third pixel electrode PE3 may extend in the third direction DR3, each of the second sides S32 may extend in the fourth direction DR4, and each of the third sides S33 may extend in the first direction DR1 or the second direction DR2.

The second pixel electrode PE2 may include two first sides S21 and two second sides S22. The two first sides S21 of the second pixel electrode PE2 may face each other, and the two second sides S22 may face each other. Each of the first sides S21 of the second pixel electrode PE2 may extend in the fourth direction DR4 or the third direction DR3, and each of the second sides S22 may extend in the third direction DR3 or the fourth direction DR4.

The first sides S21 of the second pixel electrode PE2 may be parallel to the second sides S12 or the first sides S11 of the first pixel electrode PE1, and the second sides S22 of the second pixel electrode PE2 may be parallel to the first sides S31 or the second sides S32 of the third pixel electrode PE3. In an embodiment, a length L12 or L11 of each of the second sides S12 or the first sides S11 of the first pixel electrode PE1 may be shorter than a length L31 or L32 of each of the first sides S31 or the second sides S32 of the third pixel electrode PE3.

The first sides S11 of the first pixel electrode PE1 may be parallel to the first sides S31 of the third pixel electrode PE3, and the second sides S12 of the first pixel electrode PE1 may be parallel to the second sides S32 of the third pixel electrode PE3. For example, the length L11 of each of the first sides S11 of the first pixel electrode PE1 may be substantially the same as the length L12 of each of the second sides S12 of the first pixel electrode PE1, and the length L31 of each of the first sides S31 of the third pixel electrode PE3 may be substantially the same as the length L32 of each of the second sides S32 of the third pixel electrode PE3.

In an embodiment, the length L21 of each of the first sides S21 of the second pixel electrode PE2 may be substantially the same as the length L12 or L11 of each of the second sides S12 or the first sides S11 of the first pixel electrode PE1, and the length L22 of each of the second sides S22 of the second pixel electrode PE2 may be substantially the same as the length L31or L32 of each of the first sides S31 or the second sides S32 of the third pixel electrode PE3. That is, the length L21 of each of the first sides S21 of the second pixel electrode PE2 may be shorter than the length L22 of each of the second sides S22 of the second pixel electrode PE2.

The third sides S13 of the first pixel electrode PE1 may be parallel to the third sides S33 of the third pixel electrode PE3. In an embodiment, the length L13 of each of the third sides S13 of the first pixel electrode PE1 may be substantially the same as the length L33 of each of the third sides S33 of the third pixel electrode PE3.

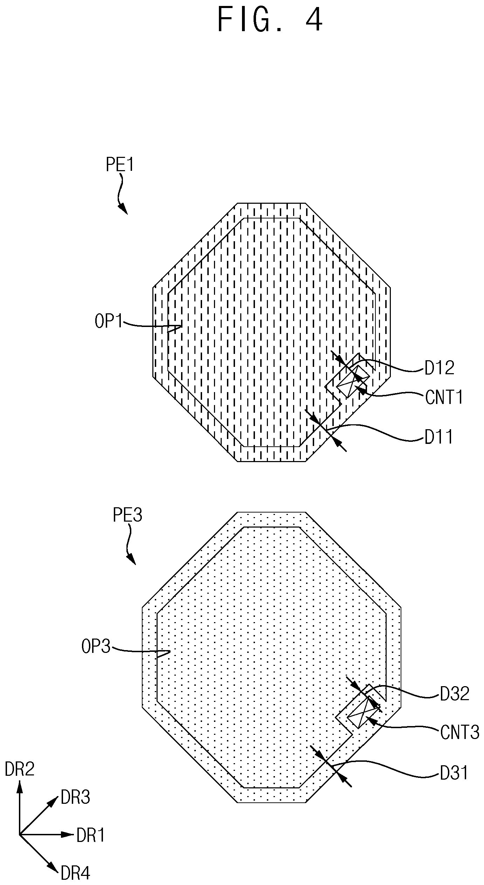

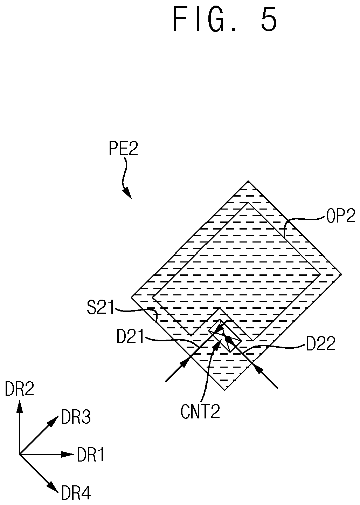

FIG. 4 is a plan view for explaining a relationship between a first pixel electrode, a first pixel opening, and a first contact hole, and a relationship between a second pixel electrode, a second pixel opening, and a second contact hole in FIG. 2. FIG. 5 is a plan view for explaining a relationship between a third pixel electrode, a third pixel opening, and a third contact hole of FIG. 2.

Referring to FIGS. 4 and 5, in an embodiment, a shortest distance D11 between an edge of the first pixel opening OP1 and an edge of the first pixel electrode PE1 may be longer than a shortest distance D12 between the edge of the first pixel opening OP1 and an edge of the first contact hole CNT1.

Likewise, in an embodiment, a shortest distance D31 between an edge of the third pixel opening OP3 and an edge of the third pixel electrode PE3 may be longer than a shortest distance D32 between the edge of the third pixel opening OP3 and an edge of the third contact hole CNT3.

In an embodiment, a shortest distance D21 between an edge of the second pixel electrode PE2 and an edge of the second contact hole CNT2 in the third direction DR3 may be longer than a shortest distance D22 between the edge of the second pixel electrode PE2 and the edge of the second contact hole CNT2 in the fourth direction DR4. That is, the shortest distance D21 between the first side S21 of the second pixel electrode PE2 and the edge of the second contact hole CNT2 may be longer than the shortest distance D22 between the second side S22, which is longer than the first side S21 of the second pixel electrode PE2, and the edge of the second contact hole CNT2.

FIG. 6 is a cross-sectional view taken along line I-I' of FIG. 2.

Referring to FIG. 6, the display device DD according to an embodiment of the present disclosure may include a substrate SUB, a buffer layer BUF, the first, second, and third transistors TR1, TR2, and TR3, a gate insulating layer GI, an interlayer insulating layer ILD, a via insulating layer VIA, the first, second, and third light emitting elements LED1, LED2, and LED3, the pixel defining layer PDL, and an encapsulation layer TFE.

Here, the first transistor TR1 may include a first active pattern ACT1, a first gate electrode GE1, a first source electrode SE1, and a first drain electrode DE1, the second transistor TR2 may include a second active pattern ACT2, a second gate electrode GE2, a second source electrode SE2, and a second drain electrode DE2, and the third transistor TR3 may include a third active pattern ACT3, a third gate electrode GE3, a third source electrode SE3, and a third drain electrode DE3.

In addition, the first light emitting element LED1 may include the first pixel electrode PE1, the first light emitting layer EML1, and a common electrode CE, the second light emitting element LED2 may include the second pixel electrode PE2, the second light emitting layer EML2, and the common electrode CE, and the third light emitting element LED3 may include the third pixel electrode PE3, the third light emitting layer EML3, and the common electrode CE.

As described above, the display device DD may include the display area DA including the first, second, and third pixel areas PX1, PX2, and PX3. As the display device DD includes the display area DA including the first, second, and third pixel areas PX1, PX2, and PX3, the substrate SUB may also include the first, second, and third pixel areas PX1, PX2, and PX3.

The substrate SUB may include a transparent material or an opaque material. The substrate SUB may be made of a transparent resin substrate. Examples of the transparent resin substrate include a polyimide substrate. In this case, the polyimide substrate may include a first organic layer, a first barrier layer, a second organic layer, and the like. Alternatively, the substrate SUB may include a quartz substrate, a synthetic quartz substrate, a calcium fluoride substrate, a fluorine-doped quartz substrate, a soda-lime glass substrate, non-alkali glass substrate, and the like. These can be used alone or in combination with each other.

The buffer layer BUF may be disposed on the substrate SUB. The buffer layer BUF can prevent metal atoms or impurities from diffusing from the substrate SUB to the first, second, and third transistors TR1, TR2, and TR3. In addition, the buffer layer BUF can improve the flatness of the surface of the substrate SUB when the surface of the substrate SUB is not uniform. For example, the buffer layer BUF may include an inorganic insulating material such as silicon oxide (SiOₓ), silicon nitride (SiNₓ), silicon oxynitride (SiOₓN_{y}), and the like. These can be used alone or in combination with each other.

The first, second, and third active patterns ACT1, ACT2, and ACT3 may be disposed on the buffer layer BUF. Each of the first, second, and third active patterns ACT1, ACT2, and ACT3 may include a metal oxide semiconductor, an inorganic semiconductor (e.g., amorphous silicon, polysilicon), or an organic semiconductor. Each of the first, second, and third active patterns ACT1, ACT2, and ACT3 may include a source region, a drain region, and a channel region located between the source region and the drain region. The first, second, and third active patterns ACT1, ACT2, and ACT3 may be formed through the same process and may include the same material.

The metal oxide semiconductor may include a two-component compound (ABₓ), a three-component compound (ABₓC_{y}), a four-component compound (ABₓCyD_{z}), and the like containing indium (In), zinc (Zn), gallium (Ga), tin (Sn), titanium (Ti), aluminium (Al), hafnium (Hf), zirconium (Zr), magnesium (Mg), and the like. For example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), and the like. These can be used alone or in combination with each other.

The gate insulating layer GI may be disposed on the buffer layer BUF. The gate insulating layer GI may sufficiently cover the first, second, and third active patterns ACT1, ACT2, and ACT3, and may have a substantially flat upper surface without creating steps around the first, second, and third active patterns ACT1, ACT2, and ACT3. Alternatively, the gate insulating layer GI may cover the first, second, and third active patterns ACT1, ACT2, and ACT3, and may be disposed with a uniform thickness along the profile of each of the first, second, and third active patterns ACT1, ACT2, and ACT3. For example, the gate insulating layer (GI) may include an inorganic material such as silicon oxide (SiOₓ), silicon nitride (SiNₓ), silicon carbide (SiCₓ), silicon oxynitride (SiOₓN_{y}), silicon oxycarbide (SiOₓC_{y}), and the like. These can be used alone or in combination with each other.

The first, second, and third gate electrodes GE1, GE2, and GE3 may be disposed on the gate insulating layer GI. The first gate electrode GE1 may overlap the channel area of the first active pattern ACT1, the second gate electrode GE2 may overlap the channel area of the second active pattern ACT2, and the third gate electrode GE3 may overlap the channel area of the third active pattern ACT3.

Each of the first, second, and third gate electrodes GE1, GE2, and GE3 may include metal, alloy metal nitride, conductive metal oxide, transparent conductive material, and the like. Examples of the metal may include silver (Ag), molybdenum (Mo), aluminium (Al), tungsten (W), copper (Cu), nickel (Ni), chromium (Cr), titanium (Ti), and tantalum (Ta), platinum (Pt), scandium (Sc), and the like. Examples of the conductive metal oxide may include indium tin oxide, indium zinc oxide, and the like. In addition, examples of the metal nitride may include aluminium nitride (AlNₓ), tungsten nitride (WNₓ), chromium nitride (CrNₓ), and the like. These can be used alone or in combination with each other.

The first, second, and third gate electrodes GE1, GE2, and GE3 may be formed through the same process and may include the same material.

The interlayer insulating layer ILD may be disposed on the gate insulating layer GI. The interlayer insulating layer ILD may sufficiently cover the first, second, and third gate electrodes GE1, GE2, and GE3 and may have a substantially flat upper surface without creating steps around the first, second, and third gate electrodes GE1, GE2, and GE3. Alternatively, the interlayer insulating layer ILD may cover the first, second, and third gate electrodes GE1, GE2, and GE3 and may be disposed with a uniform thickness along the profile of each of the first, second, and third gate electrodes GE1, GE2, and GE3. For example, the interlayer insulating layer ILD may include an inorganic material such as silicon oxide, silicon nitride, silicon carbide, silicon oxynitride, silicon oxycarbide, and the like. These can be used alone or in combination with each other.

The first, second, and third source electrodes SE1, SE2, and SE3 may be disposed on the interlayer insulating layer ILD. The first source electrode SE1 may be connected to the source region of the first active pattern ACT1 through a contact hole formed through the gate insulating layer GI and the interlayer insulating layer ILD. The second source electrode SE2 may be connected to the source region of the second active pattern ACT2 through a contact hole formed through the gate insulating layer GI and the interlayer insulating layer ILD. The third source electrode SE3 may be connected to the source region of the third active pattern ACT3 through a contact hole formed through the gate insulating layer GI and the interlayer insulating layer ILD.

The first, second, and third drain electrodes DE1, DE2, and DE3 may be disposed on the interlayer insulating layer ILD. The first drain electrode DE1 may be connected to the drain region of the first active pattern ACT1 through a contact hole formed through the gate insulating layer GI and the interlayer insulating layer ILD. The second drain electrode DE2 may be connected to the drain region of the second active pattern ACT2 through a contact hole formed through the gate insulating layer GI and the interlayer insulating layer ILD. The third drain electrode DE3 may be connected to the drain region of the third active pattern ACT3 through a contact hole formed through the gate insulating layer GI and the interlayer insulating layer ILD.

For example, each of the first, second, and third source electrodes SE1, SE2, and SE3 may include metal, alloy, metal nitride, conductive metal oxide, transparent conductive material, and the like. These can be used alone or in combination with each other. The first, second, and third drain electrodes DE1, DE2, and DE3 may be formed through the same process as the first, second, and third source electrodes SE1, SE2, and SE3, and may include the same material as the first, second, and third source electrodes SE1, SE2, and SE3.

Accordingly, the first transistor TR1 including the first active pattern ACT1, the first gate electrode GE1, the first source electrode SE1, and the first drain electrode DE1 may be disposed on the substrate SUB, the second transistor TR2 including the second active pattern ACT2, the second gate electrode GE2, the second source electrode SE2, and the second drain electrode DE2 may be disposed on the substrate SUB, and the third transistor TR3 including the third active pattern ACT3, the third gate electrode GE3, the third source electrode SE3, and the third drain electrode DE3 may be disposed on the substrate SUB.

The via insulating layer VIA may be disposed on the interlayer insulating layer ILD. The via insulating layer VIA may sufficiently cover the first, second, and third source electrodes SE1, SE2, and SE3 and the first, second, and third drain electrodes DE1, DE2, and DE3. The via insulating layer VIA may have a substantially flat upper surface.

The via insulating layer VIA may include an organic material. For example, the via insulating layer VIA may include an organic material such as phenolic resin, polyacrylate resin, polyimide resin, polyamide resin, siloxane resin, epoxy resin, and the like. These can be used alone or in combination with each other.

The first, second, and third pixel electrodes PE1, PE2, and PE3 may be disposed on the via insulating layer VIA. The first pixel electrode PE1 may overlap the first pixel area PX1, the second pixel electrode PE2 may overlap the second pixel area PX2, and the third pixel electrode PE3 may overlap the third pixel area PX3.

The first pixel electrode PE1 may be connected to the first drain electrode DE1 through the first contact hole CNT1 formed through the via insulating layer VIA, the second pixel electrode PE2 may be connected to the second drain electrode DE2 through the second contact hole CNT2 formed through the via insulating layer VIA, and the third pixel electrode PE3 may be connected to the third drain electrode DE3 through the third contact hole CNT3 formed through the via insulating layer VIA.

Accordingly, the first pixel electrode PE1 may be electrically connected to the first transistor TR1 through the first contact hole CNT1, the second pixel electrode PE2 may be electrically connected to the second transistor TR2 through the second contact hole CNT2, and the third pixel electrode PE3 may be electrically connected to the third transistor TR3 through the third contact hole CNT3.

For example, each of the first, second, and third pixel electrodes PE1, PE2, and PE3 may include metal, alloy, metal nitride, conductive metal oxide, transparent conductive material, and the like. These can be used alone or in combination with each other. In an embodiment, each of the first, second, and third pixel electrodes PE1, PE2, and PE3 may have a stacked structure including ITO/Ag/ITO. The first, second, and third pixel electrodes PE1, PE2, and PE3 may be formed through the same process and may include the same material.

The pixel defining layer PDL may be disposed on the via insulating layer VIA. The pixel defining layer PDL may cover the edges of each of the first, second, and third pixel electrodes PE1, PE2, and PE3. In addition, the pixel defining layer PDL may define the first, second, and third pixel openings OP1, OP2, and OP3 exposing at least a part of the upper surface of each of the first, second, and third pixel electrodes PE1, PE2, and PE3.

As described above, the pixel defining layer PDL may overlap the first, second, and third contact holes CNT1, CNT2, and CNT3 in the plan view. That is, the pixel defining layer PDL may cover the first, second, and third contact holes CNT1, CNT2, and CNT3 in the plan view.

The first light emitting layer EML1 may be disposed on the first pixel electrode PE1, the second light emitting layer EML2 may be disposed on the second pixel electrode PE2, and the third light emitting layer EML3 may be disposed on the third pixel electrode PE3. Specifically, the first light emitting layer EML1 may be disposed in the first pixel opening OP1, the second light emitting layer EML2 may be disposed in the second pixel opening OP2, and the third light emitting layer EML3 may be disposed in the third pixel opening OP3

Each of the first, second, and third light emitting layers EML1, EML2, and EML3 may include an organic material which emits light of a preset color. For example, the first light emitting layer EML1 may include an organic material which generates red light, the second light emitting layer EML2 may include an organic material which generates green light, and the third light emitting layer EML3 may include an organic material which generates blue light.

In an embodiment, in the plan view, the first light emitting layer EML1 may not overlap the first contact hole CNT1, the second light emitting layer EML2 may not overlap the second contact hole CNT2, and the third light emitting layer EML3 may not overlap the third contact hole CNT3. That is, in the plan view, the first light emitting layer EML1 may be spaced apart from the first contact hole CNT1, the second light emitting layer EML2 may be spaced apart from the second contact hole CNT2, and the third light emitting layer EML3 may be spaced apart from the third contact hole CNT3.

For example, each of the first, second, and third light emitting layers EML1, EML2, and EML3 may be formed using a fine metal mask (FMM). Alternatively, each of the first, second, and third light emitting layers EML1, EML2, and EML3 may be formed through a photolithography process without using the fine metal mask.

The common electrode CE may be disposed on the pixel defining layer PDL and the first, second, and third light emitting layers EML1, EML2, and EML3. For example, the common electrode CE may include metal, alloy, metal nitride, conductive metal oxide, transparent conductive material, and the like. These can be used alone or in combination with each other.

Accordingly, the first light emitting element LED1 including the first pixel electrode PE1, the first light emitting layer EML1, and the common electrode CE may be disposed in the first pixel area PX1 on the substrate SUB, the second light emitting element LED2 including the second pixel electrode PE2, the second light emitting layer EML2, and the common electrode CE may be disposed in the second pixel area PX2 on the substrate SUB, and the third light emitting element LED3 including the third pixel electrode PE3, the third light emitting layer EML3, and the common electrode CE may be disposed in the third pixel area PX3 on the substrate SUB.

The encapsulation layer TFE may be disposed on the common electrode CE. The encapsulation layer TFE can prevent impurities, moisture, external air, and the like from penetrating into the first, second, and third light emitting elements LED1, LED2, and LED3 from the outside. The encapsulation layer TFE may include at least one inorganic layer and at least one organic layer. For example, the inorganic layer may include silicon oxide, silicon nitride, silicon oxynitride, and the like. These can be used alone or in combination with each other. The organic layer may include a cured polymer such as polyacrylate.

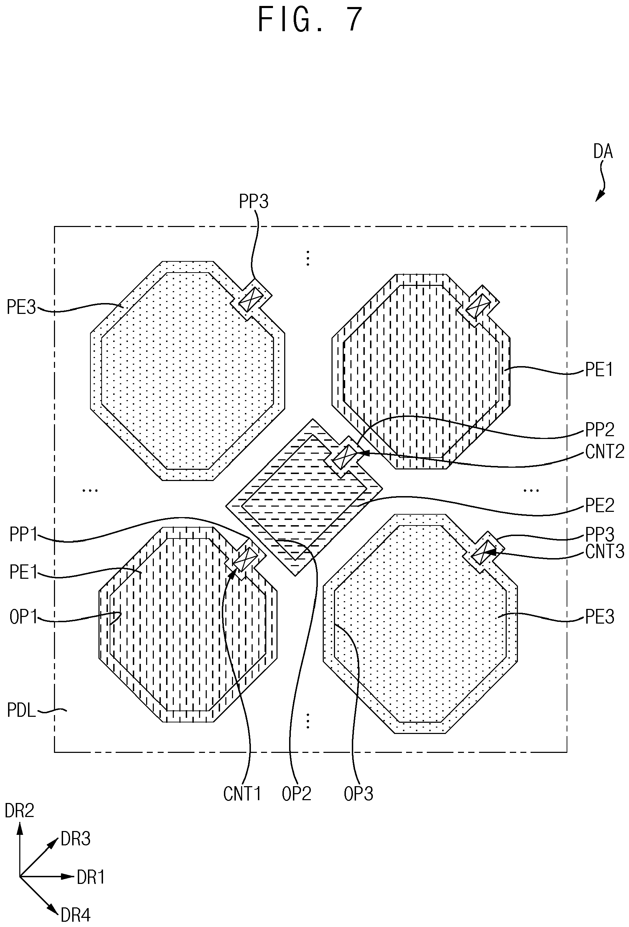

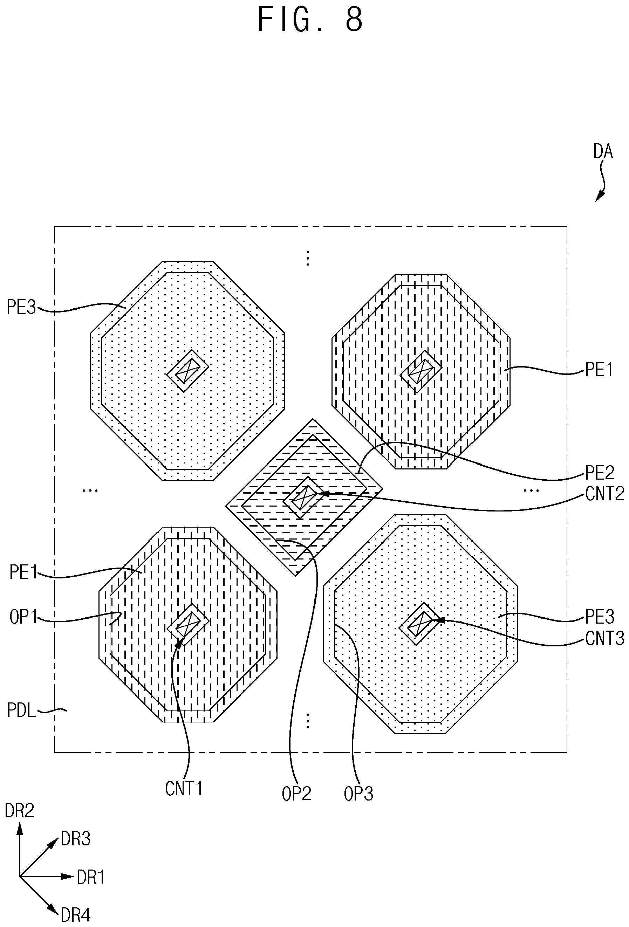

FIGS. 7 and 8 are plan views illustrating examples of a first contact hole, a second contact hole, and a third contact hole of FIG. 2.

Referring to FIG. 7, as described above, at least one contact hole among the first, second, and third contact holes CNT1, CNT2, and CNT3 may be positioned at an edge of a pixel electrode adjacent to the at least one contact hole among the first, second, and third pixel electrodes PE1, PE2, and PE3.

In an embodiment, at least one pixel electrode among the first, second, and third pixel electrodes PE1, PE2, and PE3 may include a protrusion positioned in one side, and a contact hole may be positioned in the protrusion. For example, the first pixel electrode PE1 may include a first protrusion PP1 in one side of which a first contact hole CNT1 is positioned, the second pixel electrode PE2 may include a second protrusion PP2 in one side of which a second contact hole CNT2 is positioned, and the third pixel electrode PE3 may include a third protrusion PP3 in one side of which a third contact hole CNT3 is positioned

Specifically, the first, second, and third contact holes CNT1, CNT2, and CNT3 may partially overlap the first, second, and third protrusions PP1, PP2, and PP3 in the plan view, respectively. Accordingly, each of the first, second, and third pixel electrodes PE1, PE2, and PE3 may have an asymmetric shape with respect to the center.

Referring to FIG. 8, in an embodiment, at least one contact hole among the first, second, and third contact holes CNT1, CNT2, and CNT3 may be positioned at the center of a pixel electrode adjacent to the at least one contact hole among the first, second, and third pixel electrodes PE1, PE2, and PE3. For example, the first contact hole CNT1 may be positioned at the center of the first pixel electrode PE1, the second contact hole CNT2 may be positioned at the center of the second pixel electrode PE2, and the third contact hole CNT3 may be positioned at the center of the third pixel electrode PE3. In this case, the first, second, and third contact holes CNT1, CNT2, and CNT3 may overlap the pixel defining layer PDL in the plan view. That is, the pixel defining layer PDL may cover the first, second, and third contact holes CNT1, CNT2, and CNT3.

However, embodiments of the present disclosure are not limited to this, and the location of a contact hole in a pixel electrode may vary.

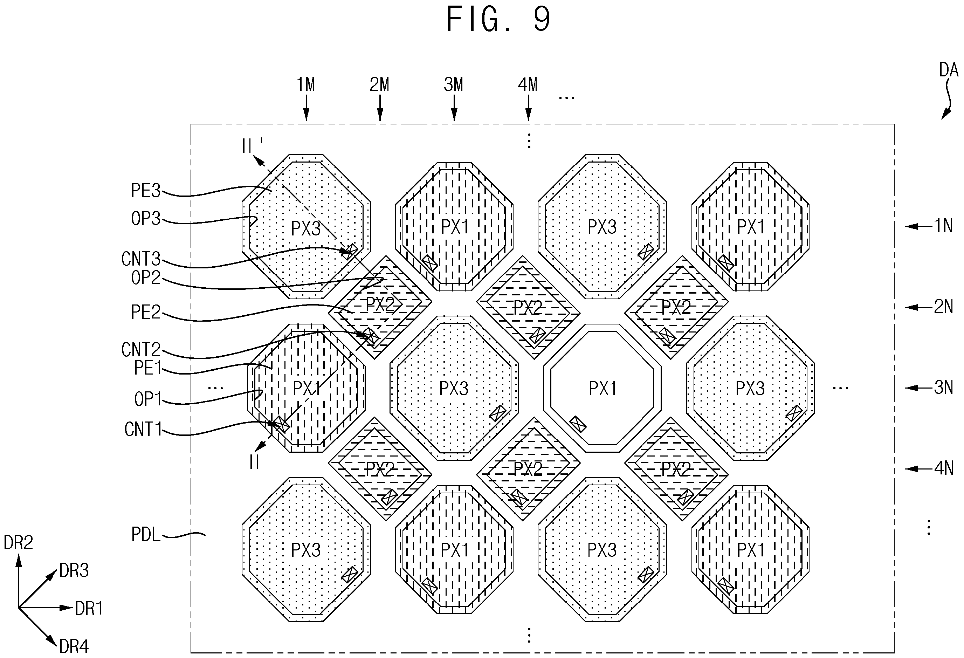

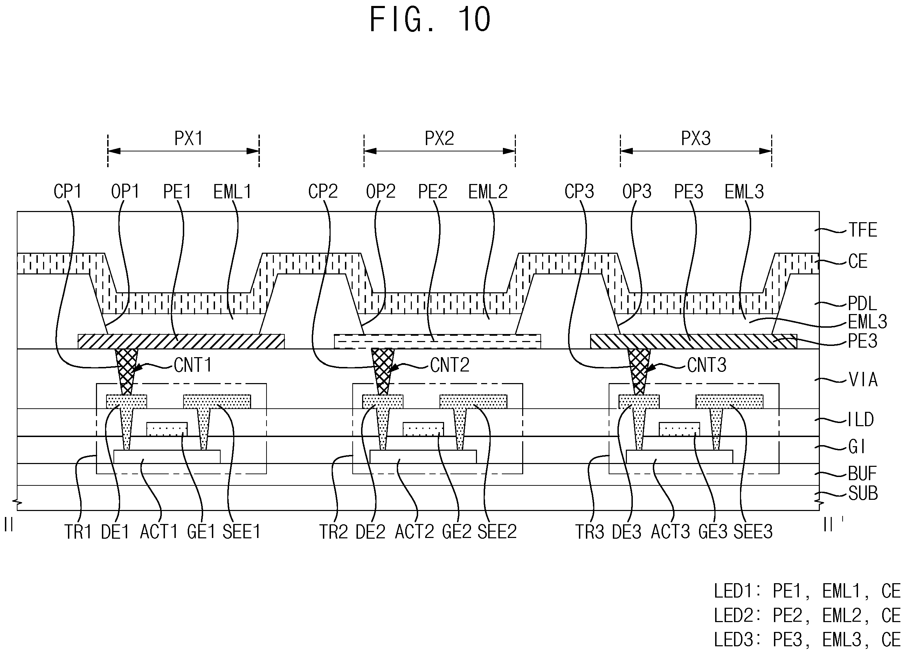

FIG. 9 is an enlarged plan view of another example of a part of the display area of FIG. 1. FIG. 10 is a cross-sectional view taken along line II-II' of FIG. 9.

Referring to FIGS. 9 and 10, the display device DD according to an embodiment of the present disclosure may include the substrate SUB, the buffer layer BUF, the first, second, and third transistors TR1, TR2, and TR3, the gate insulating layer GI, the interlayer insulating layer ILD, the via insulating layer VIA, first, second, and third conductive patterns CP1, CP2, and CP3, the first, second, and third light emitting elements LED1, LED2, and LED3, the pixel defining layer PDL, and the encapsulation layer TFE.

The display area DA of the display device DD may include the first, second, and third pixel areas PX1, PX2, and PX3. The arrangement of the first, second, and third pixel areas PX1, PX2, and PX3 of FIG. 9 may be substantially the same as the arrangement of the first, second, and third pixel areas PX1, PX2, and PX3 of FIG. 2.

The first, second, and third contact holes CNT1, CNT2, and CNT3 may be formed through the via insulating layer VIA. In an embodiment, the first contact hole CNT1 may be filled with the first conductive pattern CP1, the second contact hole CNT2 may be filled with the second conductive pattern CP2, and the third contact hole CNT3 may be filled with the third conductive pattern CP3. Accordingly, the first conductive pattern CP1 may be connected to the first drain electrode DE1, the second conductive pattern CP2 may be connected to the second drain electrode DE2, and the third conductive pattern CP3 may be connected to the third drain electrode DE3.

The first, second, and third conductive patterns CP1, CP2, and CP3 may be formed through the same process and may include the same material.

In an embodiment, the first, second, and third conductive patterns CP1, CP2, and CP3 may be formed through a chemical mechanical polishing (CMP) process. Accordingly, each of the first, second, and third conductive patterns CP1, CP2, and CP3 may have a substantially flat upper surface.

The first pixel electrode PE1 may be disposed in the first pixel area PX1 on the via insulating layer VIA, the second pixel electrode PE2 may be disposed in the second pixel area PX2 on the via insulating layer VIA, and the third pixel electrode PE3 may be disposed in the third pixel area PX3 on the via insulating layer VIA.

The first pixel electrode PE1 may contact the first conductive pattern CP1, the second pixel electrode PE2 may contact the second conductive pattern CP2, and the third pixel electrode PE3 may contact the third conductive pattern CP3. Accordingly, the first pixel electrode PE1 may be electrically connected to the first transistor TR1 through the first conductive pattern CP1, the second pixel electrode PE2 may be electrically connected to the second transistor TR2 through the second conductive pattern CP2, and the third pixel electrode PE3 may be electrically connected to the third transistor TR3 through the third conductive pattern CP3.

The shape, size, and arrangement of the first, second, and third pixel electrodes PE1, PE2, and PE3 of FIG. 9 may be substantially the same as the shape, size, and arrangement of the first, second, and third pixel electrodes PE1, PE2, and PE3 of FIGS. 2 and 3.

In an embodiment, the first, second, and third conductive patterns CP1, CP2, and CP3 may include a conductive material different from a conductive material of the first, second, and third pixel electrodes PE1, PE2, and PE3. That is, the first, second, and third conductive patterns CP1, CP2, and CP3 may be formed through a different process from the first, second, and third pixel electrodes PE1, PE2, and PE3.

In an embodiment, the first, second, and third light emitting layers EML1, EML2, and EML3 may at least partially overlap the first, second, and third contact holes CNT1, CNT2, and CNT3 in the plan view, respectively. That is, the first, second, and third contact holes CNT1, CNT2, and CNT3 may not be covered by the pixel defining layer PDL. In other words, by filling the first, second, and third contact holes CNT1, CNT2, and CNT3 with the first, second, and third conductive patterns CP1, CP2, and CP3, respectively, it may be possible to dispose the first, second, and third light emitting layers EML1, EML2, and EML3 to overlap the first, second, and third contact holes CNT1, CNT2, and CNT3, respectively.

However, embodiments of the present disclosure are not limited to this, and the first, second, and third contact holes CNT1, CNT2, and CNT3 may be covered by the pixel defining layer PDL.

In an embodiment, the planar shape of the first pixel opening OP1 may substantially correspond to the planar shape of the first pixel electrode PE1, the planar shape of the second pixel opening OP2 may substantially correspond to the planar shape of the second pixel electrode PE2, and the planar shape of the third pixel opening OP3 may substantially correspond to the planar shape of the third pixel electrode PE3. The sides of the first, second, and third pixel openings OP1, OP2, and OP3 may be parallel to the sides of the first, second, and third pixel electrodes PE1, PE2, and PE3, respectively. In other words, each of the first and third pixel openings OP1 and OP3 may have a substantially octagonal planar shape, and the second pixel opening OP2 may have a substantially quadrangle planar shape.

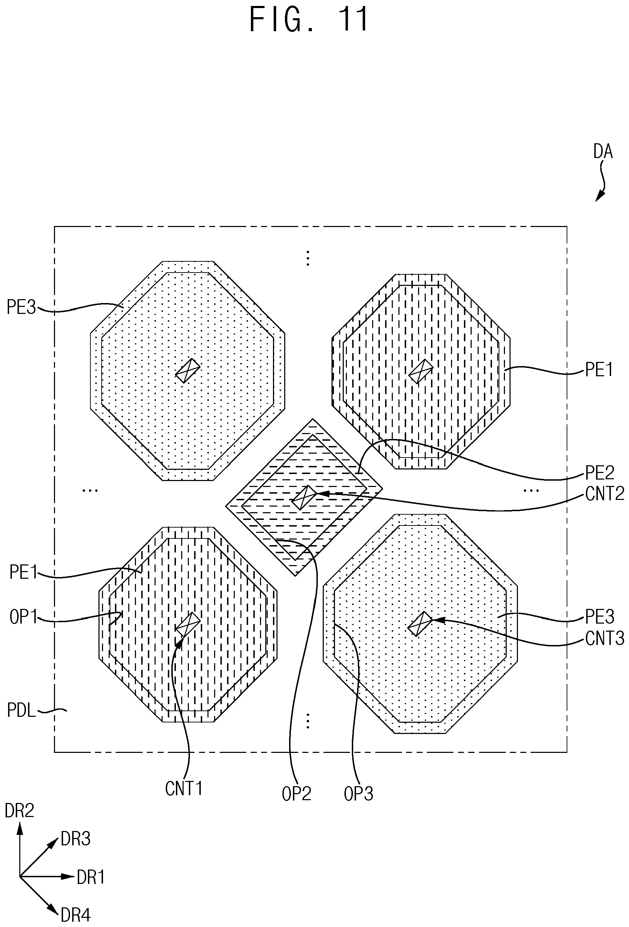

FIG. 11 is a plan view illustrating an example of a first contact hole, a second contact hole, and a third contact hole of FIG. 9.

Referring again to FIG. 9, at least one contact hole among the first, second, and third contact holes CNT1, CNT2, and CNT3 may be positioned at an edge of a pixel electrode adjacent to the at least one contact hole among the first, second, and third pixel electrodes PE1, PE2, and PE3. In this case, for example, the pixel electrode may not include a protrusion positioned in one side. Alternatively, as shown in FIG. 7, the pixel electrode may include the protrusion located on one side, and the at least one contact hole may be positioned in the protrusion. In this case, the at least one contact hole may partially overlap the protrusion in the plan view.

Referring to FIG. 11, in an embodiment, at least one contact hole among the first, second, and third contact holes CNT1, CNT2, and CNT3 may be positioned at the center of a pixel electrode adjacent to the at least one contact hole among the first, second, and third pixel electrodes PE1, PE2, and PE3.

For example, the first contact hole CNT1 may be positioned at the center of the first pixel electrode PE1, the second contact hole CNT2 may be positioned at the center of the second pixel electrode PE2, and the third contact hole CNT3 may be positioned at the center of the third pixel electrode PE. In this case, the first, second, and third contact holes CNT1, CNT2, and CNT3 may respectively overlap the first, second, and third pixel openings OP1, OP2, and OP3 in plan view. That is, the first, second, and third contact holes CNT1, CNT2, and CNT3 may overlap the first, second, and third light emitting layers (e.g., the first, second, and third light emitting layers EML1, EML2, and EML3 of FIG. 10) in plan view, respectively.

However, embodiments of the present disclosure are not limited to this, and the location of a contact hole in a pixel electrode may vary.

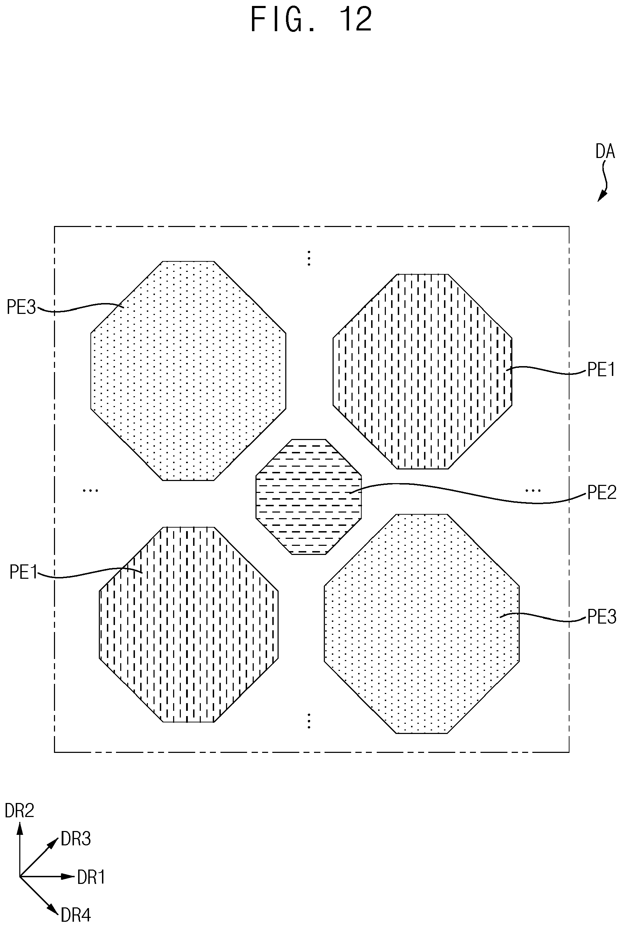

FIGS. 12, 13, 14, 15, 16, 17, and 18 are plan views illustrating examples of the planar shape of each of first, second, and third pixel electrodes of FIGS. 2 and 9.

Referring to FIG. 12, in an embodiment, each of the first and third pixel electrodes PE1 and PE3 may have an octagonal planar shape, and the second pixel electrode PE2 may have an octagonal planar shape. That is, the first, second, and third pixel electrodes PE1 and PE3 may have different sizes but have the same octagonal planar shape.

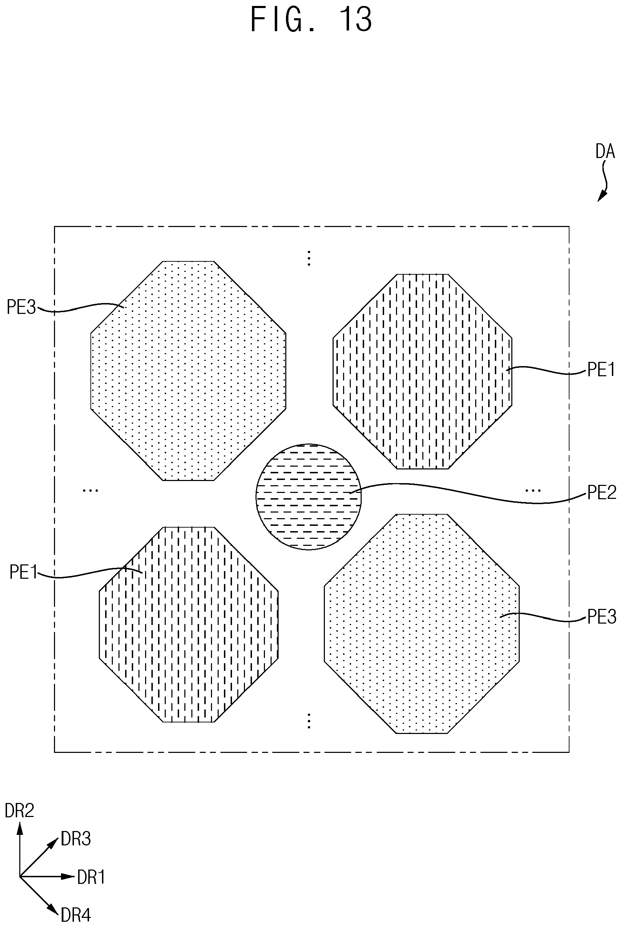

Referring to FIG. 13, in an embodiment, each of the first and third pixel electrodes PE1 and PE3 may have an octagonal planar shape, and the second pixel electrode PE2 may have a circular planar shape.

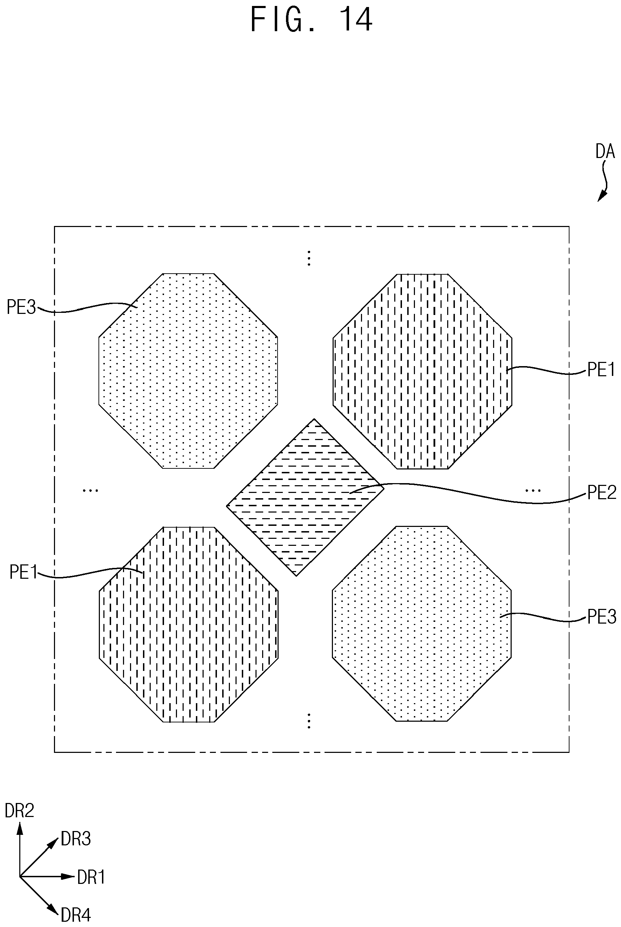

Referring to FIG. 14, in an embodiment, each of the first and third pixel electrodes PE1 and PE3 may have an octagonal planar shape, and the second pixel electrode PE2 may have a rectangular planar shape. In this case, the size of the first pixel electrode PE1 and the size of the third pixel electrode PE3 may be substantially the same.

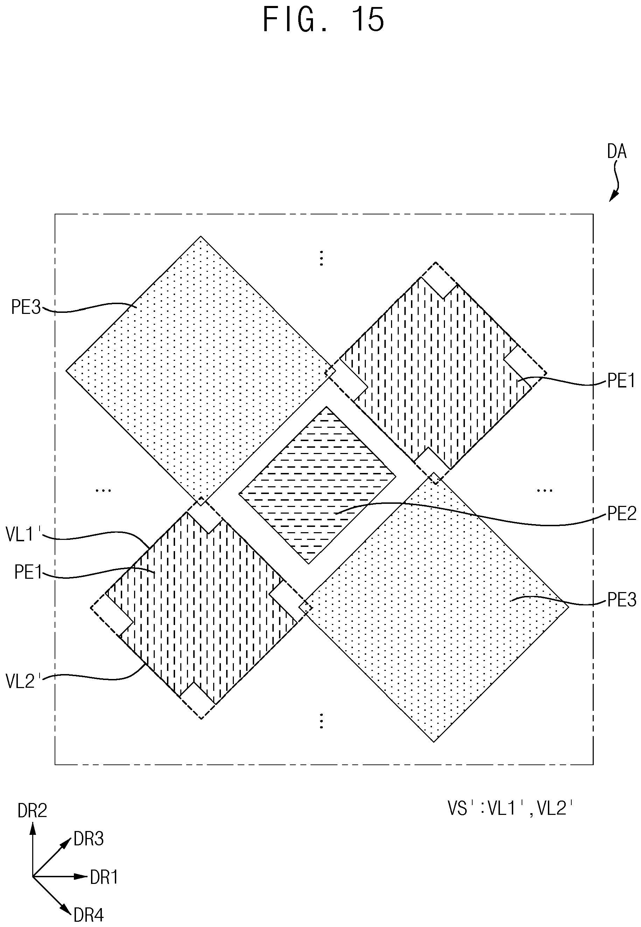

Referring to FIG. 15, each of the first, second, and third pixel electrodes PE1, PE2, and PE3 may have a polygonal planar shape. In an embodiment, the first pixel electrode PE1 may have a quadrangle (e.g., square or diamond) planar shape including a chamfered corner part, the third pixel electrode PE3 may have a quadrangle (e.g., square or diamond) or octagonal planar shape, and the second pixel electrode PE2 may have a quadrangle (e.g., rectangular) planar shape. Specifically, the chamfered corner part of the first pixel electrode PE1 may surround at least a part of a corner part of the third pixel electrode PE3 facing each other in the plan view.

A virtual first line VL1' extending to coincide with first sides extending in the third direction DR3 of the first pixel electrode PE1 and a virtual second line VL2' extending to coincide with second sides of the first pixel electrode PE1 may define a virtual quadrangle VS'. In an embodiment, the virtual quadrangle VS' may at least partially overlap the adjacent third pixel electrode PE3 in the plan view.

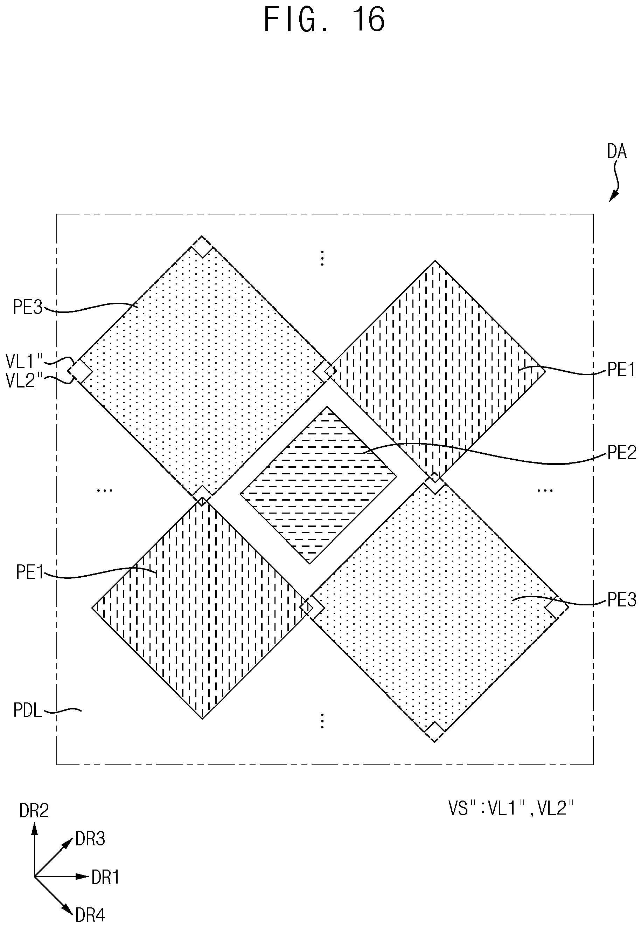

Referring to FIG. 16, each of the first, second, and third pixel electrodes PE1, PE2, and PE3 may have a polygonal planar shape. In an embodiment, the first pixel electrode PE1 may have a quadrangle (e.g., square or diamond) planar shape, the third pixel electrode PE3 may have a quadrangle (e.g., square or diamond) including a chamfered corner part, and the second pixel electrode PE2 may have a quadrangle (e.g., rectangular) or octagonal planar shape. Specifically, the chamfered corner part of the third pixel electrode PE3 may surround at least a part of a corner part of the first pixel electrode PE1 facing each other in the plan view.

A virtual first line VL1" extending to coincide with first sides extending in the third direction DR3 of the third pixel electrode PE3 and a virtual second line VL2" extending to coincide with second sides of the third pixel electrode PE3 may define a virtual quadrangle VS". In an embodiment, the virtual quadrangle VS" may at least partially overlap the adjacent first pixel electrode PE1 in the plan view.

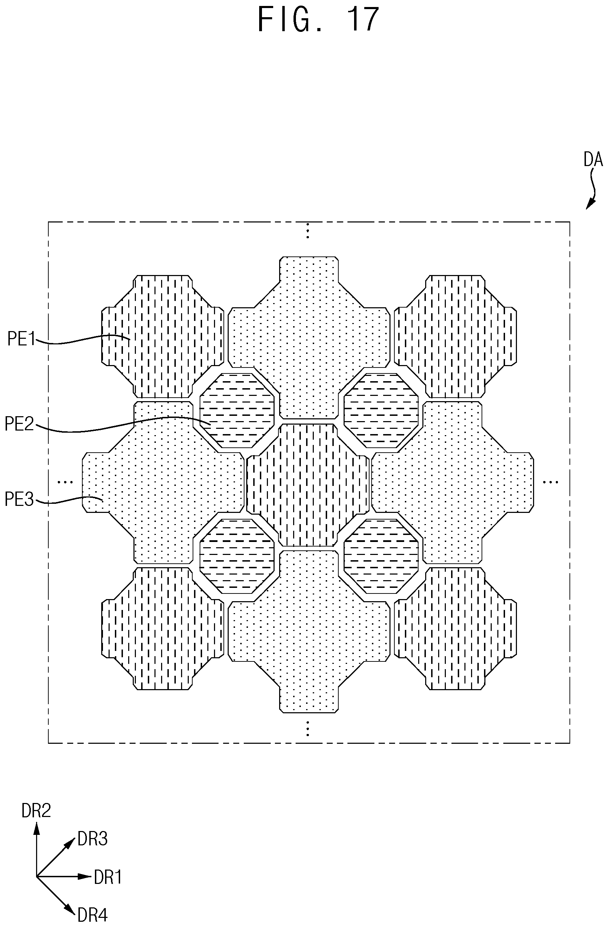

Referring to FIG. 17, each of the first, second, and third pixel electrodes PE1, PE2, and PE3 may have an octagonal planar shape. In an embodiment, each of the sides of the first pixel electrode PE1 facing the second pixel electrode PE2 may be depressed toward the center of the first pixel electrode PE1, and each of the sides of the third pixel electrode PE3 facing the second pixel electrode PE2 may be depressed toward the center of the third pixel electrode PE3. However, embodiments of the present disclosure are not limited to this, and the second pixel electrode PE2 may have a circular planar shape.

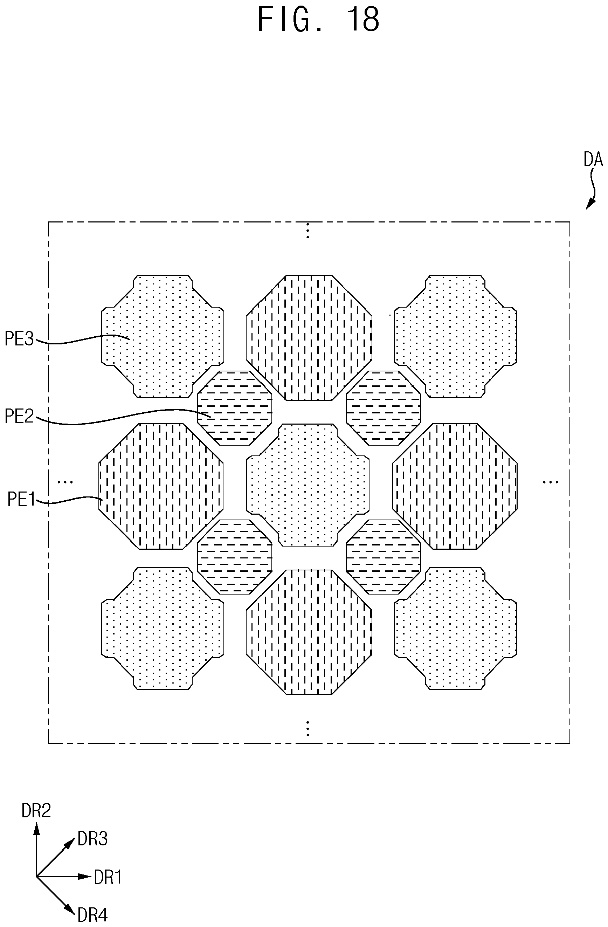

Referring to FIG. 18, each of the first, second, and third pixel electrodes PE1, PE2, and PE3 may have an octagonal planar shape. In an embodiment, each of the sides of the third pixel electrode PE3 facing the second pixel electrode PE2 may be depressed toward the center of the third pixel electrode PE3. However, embodiments of the present disclosure are not limited to this, and the second pixel electrode PE2 may have a circular planar shape.

Referring again to FIGS. 1 to 18, in the display device DD according to an embodiment of the present disclosure, each of the first pixel electrode PE1 disposed in the first pixel area PX1 which emits red light and the third pixel electrode PE3 disposed in the third pixel area PX3 which emits blue light may have an octagonal planar shape, and the second pixel electrode PE2 disposed in the second pixel area PX2 which emits green light may have a quadrangle planar shape. The first virtual quadrangle VS1 defined by a virtual line (e.g., the first and second virtual lines VL1 and VL2) extending to coincide with sides extending in a diagonal direction (e.g., the third direction DR3 and fourth direction DR4) of the first pixel electrode PE1 may at least partially overlap the second virtual quadrangle VS2 defined by a virtual line (e.g., the third and fourth virtual lines VL3 and VL24) extending to coincide with sides extending in the diagonal direction of the third pixel electrode PE3. Accordingly, the luminous efficiency of the display device DD can be prevented from being reduced.

Alternatively, in the display device DD according to an embodiment of the present disclosure, any one of the first and third pixel electrodes PE1 and PE3 may have a quadrangle planar shape including a chamfered corner part, and another of the first and third pixel electrodes PE1 and PE3may have a quadrangle or octagonal planar shape. Accordingly, the luminous efficiency of the display device DD can be prevented from being reduced.

The present disclosure can be applied to various display devices. For example, the present disclosure is applicable to various display devices such as display devices for vehicles, ships and aircraft, portable communication devices, display devices for exhibition or information transmission, medical display devices, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the present inventive concept. Accordingly, all such modifications are intended to be included within the scope of the present inventive concept as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

The present invention will now be defined with reference to the following clauses.
Clause 1. A display device comprising:
   a substrate including a first pixel area, a second pixel area, and a third pixel area which emit light of different colors;
   a first light emitting element disposed in the first pixel area on the substrate and including a first pixel electrode having an octagonal planar shape;
   a second light emitting element disposed in the second pixel area on the substrate and including a second pixel electrode;
   a third emitting element disposed in the third pixel area on the substrate and including a third pixel electrode having an octagonal planar shape; and
   a pixel defining layer covering edges of the first pixel electrode, the second pixel electrode, and the third pixel electrode and defining a first pixel opening, a second pixel opening, and a third pixel opening exposing at least a part of the first pixel electrode, the second pixel electrode, and the third pixel electrode, respectively,
   wherein a virtual first line extending to coincide with each of first sides extending in a first direction of the first pixel electrode and a virtual second line extending to coincide with each of second sides extending in a second direction perpendicular to the first direction of the first pixel electrode define a virtual first quadrangle,
   wherein a virtual third line extending to coincide with each of first sides extending in the first direction of the third pixel electrode adjacent to the first pixel electrode and a virtual fourth line extending to coincide with each of second sides extending in the second direction of the third pixel electrode define a virtual second quadrangle, and
   wherein the virtual first quadrangle at least partially overlaps the virtual second quadrangle in a plan view.
Clause 2. The display device of clause 1, wherein the second pixel electrode has a rectangular, circular, or octagonal planar shape.
Clause 3. The display device of clause 1 or clause 2, wherein the first pixel area emit red light, the second pixel area emit green light, and the third pixel area emit blue light.
Clause 4. The display device of any one of clauses 1 to 3, wherein a length of a side of the first pixel electrode extending parallel to a first side of the second pixel electrode is shorter than a length of a side of the third pixel electrode extending parallel to a second side of the second pixel electrode.
Clause 5. The display device of any one of clauses 1 to 4, wherein a length of a third side of the first pixel electrode which connects the first side and the second side of the first pixel electrode is a same as a length of a third side of the third pixel electrode which connects the first side and the second side of the third pixel electrode and extends parallel to the third side of the first pixel electrode.
Clause 6. The display device of any one of clauses 1 to 5, wherein a length of a first side of the second pixel electrode extending parallel to the second side of the first pixel electrode is the same as a length of the second side of the first pixel electrode, and wherein a length of a second side of the second pixel electrode extending parallel to the first side of the third pixel electrode is the same as a length of the first side of the third pixel electrode.
Clause 7. The display device of any one of clauses 1 to 6, wherein a planar shape of the first pixel opening substantially corresponds to a planar shape of the first pixel electrode, a planar shape of the second pixel opening substantially corresponds to a planar shape of the second pixel electrode, and a planar shape of the third pixel opening substantially corresponds to a planar shape of the third pixel electrode.
Clause 8. The display device of any one of clauses 1 to 7, wherein the first light emitting element further includes a first light emitting layer disposed in the first pixel opening, wherein the second light emitting element further includes a second light emitting layer disposed in the second pixel opening, and wherein the third light emitting element further includes a third light emitting layer disposed in the third pixel opening.
Clause 9. The display device of clause 8, further comprising:
   a first transistor connected to the first pixel electrode through a first contact hole;
   a second transistor connected to the second pixel electrode through a second contact hole; and
   a third transistor connected to the third pixel electrode through a third contact hole.
Clause 10. The display device of clause 9, wherein each of the first contact hole, the second contact hole, and the third contact hole has a rectangular planar shape.
Clause 11. The display device of clause 9 or clause 10, wherein the first contact hole does not overlap with the first light emitting layer in the plan view, the second contact hole does not overlap with the second light emitting layer in the plan view, and the third contact hole does not overlap with the third light emitting layer in the plan view.
Clause 12. The display device of any one of clauses 9 to 11, wherein at least one contact hole among the first contact hole, the second contact hole, and the third contact hole is positioned at an edge of a pixel electrode disposed adjacent to the at least one contact hole among the first pixel electrode, the second pixel electrode, and the third pixel electrode.
Clause 13. The display device of any one of clauses 9 to 12, wherein at least one pixel electrode among the first pixel electrode, the second pixel electrode, and the third pixel electrode includes a protrusion positioned in one side, and wherein at least one contact hole disposed adjacent to the at least one pixel electrode among the first contact hole, the second contact hole, and the third contact hole partially overlaps the protrusion in the plan view.
Clause 14. The display device of clause 9, wherein at least one contact hole among the first contact hole, the second contact hole, and third contact hole is positioned at a center of a pixel electrode adjacent to the at least one contact hole among the first pixel electrode, the second pixel electrode, and the third pixel electrode.
Clause 15. The display device of clause 14, wherein the at least one contact hole overlaps the pixel defining layer in the plan view.
Clause 16. The display device of any one of clauses 9 to 15, further comprising:
   a conductive pattern filling each of the first contact hole, the second contact hole, and the third contact hole, contacting each of the first pixel electrode, the second pixel electrode, and
   the third pixel electrode, and includes a conductive material different from the first pixel electrode, the second pixel electrode, and the third pixel electrode.
Clause 17. The display device of clause 16, wherein the first contact hole, the second contact hole, and the third contact hole at least partially overlap the first light emitting layer, the second light emitting layer, and the third light emitting layer in the plan view, respectively.
Clause 18. The display device of any one of clauses 1 to 17, wherein a size of the first pixel electrode is substantially a same as a size of the third pixel electrode.
Clause 19. The display device of any one of clauses 1 to 18, wherein each side of the first pixel electrode facing the second pixel electrode is depressed toward a center of the first pixel electrode and each of sides of the third pixel electrode facing the second pixel electrode is depressed toward a center of the third pixel electrode, and wherein the second pixel electrode has an octagonal or circular planar shape.
Clause 20. The display device of any one of clauses 1 to 19, wherein each side of the third pixel electrode facing the second pixel electrode is depressed toward a center of the third pixel electrode, and wherein the second pixel electrode has an octagonal or circular planar shape.
Clause 21. The display device of any one of clauses 1 to 20, wherein a virtual line extending in a third direction between the first direction and the second direction, and a fourth direction perpendicular to the third direction defines a virtual square, and wherein centers of first pixel electrodes are positioned at first vertices of the virtual square facing each other, centers of the third pixel electrodes are positioned at second vertices of the virtual square facing each other, and the second pixel electrode is positioned at a center of the virtual square.
Clause 22. A display device comprising:
   a substrate including a first pixel area, a second pixel area, and a third pixel area which emit light of different colors;
   a first light emitting element disposed in the first pixel area on the substrate and including a first pixel electrode having a polygonal planar shape;
   a second light emitting element disposed in the second pixel area on the substrate and including a second pixel electrode;
   a third emitting element disposed in the third pixel area on the substrate and including a third pixel electrode having a polygonal planar shape; and
   a pixel defining layer covering edges of each of the first pixel electrode, the second pixel electrode, and the third pixel electrode and defining a first pixel opening, a second pixel opening, and a third pixel opening exposing at least a part of the first pixel electrode, the second pixel electrode, and the third pixel electrode, respectively,
   wherein any one of the first pixel electrode and the third pixel electrode has a quadrangle planar shape including a chamfered corner part.
Clause 23. The display device of clause 22, wherein another of the first and third pixel electrodes has a quadrangle or octagonal planar shape.
Clause 24. The display device of clause 23, wherein a virtual first line extending to coincide with each of first sides extending in a first direction of the any one of the first and third pixel electrodes and a virtual second line extending to coincide with each of second sides extending in a second direction perpendicular to the first direction of the any one of the first and third pixel electrodes define a virtual quadrangle, and wherein the virtual quadrangle at least partially overlaps the another of the first and third pixel electrode in the plan view.
Clause 25. The display device of clause 23 or clause 24, wherein, when the first pixel electrode includes the chamfered corner part and the third pixel electrode has a quadrangle planar shape, the chamfered corner part of the first pixel electrode surrounds at least a part of corner part of the third pixel electrode facing each other in the plan view.
Clause 26. The display device of any one of clauses 22 to 25, wherein the second pixel electrode has a quadrangle planar shape.
Clause 27. The display device of clause 26, wherein at least one pixel electrode among the first pixel electrode, the second pixel electrode, and the third pixel electrode includes a protrusion positioned in one side, and wherein at least one contact hole adjacent to the at least one pixel electrode among the first contact hole, the second contact hole, and the third contact hole partially overlaps the protrusion in the plan view.
Clause 28. The display device of clause 26, wherein at least one contact hole among the first contact hole, the second contact hole, and the third contact hole is positioned at a center of a pixel electrode adjacent to the at least one contact hole among the first pixel electrode, the second pixel electrode, and the third pixel electrode.
Clause 29. The display device of any one of clauses 22 to 28, further comprising:
   a first transistor connected to the first pixel electrode through a first contact hole;
   a second transistor connected to the second pixel electrode through a second contact hole; and
   a third transistor connected to the third pixel electrode through a third contact hole.
Clause 30. The display device of clause 29, wherein at least one contact hole among the first contact hole, the second contact hole, and the third contact hole is positioned at an edge of a pixel electrode adjacent to the at least one contact hole among the first pixel electrode, the second pixel electrode, and the third pixel electrode.

## Claims

1. A display device comprising:
a substrate including a first pixel area, a second pixel area, and a third pixel area which emit light of different colors;
a first light emitting element disposed in the first pixel area on the substrate and including a first pixel electrode having an octagonal planar shape;
a second light emitting element disposed in the second pixel area on the substrate and including a second pixel electrode;
a third emitting element disposed in the third pixel area on the substrate and including a third pixel electrode having an octagonal planar shape; and
a pixel defining layer covering edges of the first pixel electrode, the second pixel electrode, and the third pixel electrode and defining a first pixel opening, a second pixel opening, and a third pixel opening exposing at least a part of the first pixel electrode, the second pixel electrode, and the third pixel electrode, respectively,
wherein a virtual first line extending to coincide with each of first sides extending in a first direction of the first pixel electrode and a virtual second line extending to coincide with each of second sides extending in a second direction perpendicular to the first direction of the first pixel electrode define a virtual first quadrangle,
wherein a virtual third line extending to coincide with each of first sides extending in the first direction of the third pixel electrode adjacent to the first pixel electrode and a virtual fourth line extending to coincide with each of second sides extending in the second direction of the third pixel electrode define a virtual second quadrangle, and
wherein the virtual first quadrangle at least partially overlaps the virtual second quadrangle in a plan view.

2. The display device of claim 1, wherein the second pixel electrode has a rectangular, circular, or octagonal planar shape.

3. The display device of claim 1 or claim 2, wherein the first pixel area emit red light, the second pixel area emit green light, and the third pixel area emit blue light.

4. The display device of any one of claims 1 to 3, wherein a length of a side of the first pixel electrode extending parallel to a first side of the second pixel electrode is shorter than a length of a side of the third pixel electrode extending parallel to a second side of the second pixel electrode.

5. The display device of any one of claims 1 to 4, wherein a length of a third side of the first pixel electrode which connects the first side and the second side of the first pixel electrode is a same as a length of a third side of the third pixel electrode which connects the first side and the second side of the third pixel electrode and extends parallel to the third side of the first pixel electrode.

6. The display device of any one of claims 1 to 5, wherein a length of a first side of the second pixel electrode extending parallel to the second side of the first pixel electrode is the same as a length of the second side of the first pixel electrode, and
wherein a length of a second side of the second pixel electrode extending parallel to the first side of the third pixel electrode is the same as a length of the first side of the third pixel electrode.

7. The display device of any one of claims 1 to 6, wherein a planar shape of the first pixel opening substantially corresponds to a planar shape of the first pixel electrode, a planar shape of the second pixel opening substantially corresponds to a planar shape of the second pixel electrode, and a planar shape of the third pixel opening substantially corresponds to a planar shape of the third pixel electrode.

8. The display device of any one of claims 1 to 7, wherein the first light emitting element further includes a first light emitting layer disposed in the first pixel opening,
wherein the second light emitting element further includes a second light emitting layer disposed in the second pixel opening, and
wherein the third light emitting element further includes a third light emitting layer disposed in the third pixel opening.

9. The display device of claim 8, further comprising:
a first transistor connected to the first pixel electrode through a first contact hole;
a second transistor connected to the second pixel electrode through a second contact hole; and
a third transistor connected to the third pixel electrode through a third contact hole.

10. The display device of claim 9, wherein:
(i) each of the first contact hole, the second contact hole, and the third contact hole has a rectangular planar shape; and/or
(ii) the first contact hole does not overlap with the first light emitting layer in the plan view, the second contact hole does not overlap with the second light emitting layer in the plan view, and the third contact hole does not overlap with the third light emitting layer in the plan view; and/or
(iii) at least one contact hole among the first contact hole, the second contact hole, and the third contact hole is positioned at an edge of a pixel electrode disposed adjacent to the at least one contact hole among the first pixel electrode, the second pixel electrode, and the third pixel electrode; and/or
(iv) wherein at least one pixel electrode among the first pixel electrode, the second pixel electrode, and the third pixel electrode includes a protrusion positioned in one side, and
wherein at least one contact hole disposed adjacent to the at least one pixel electrode among the first contact hole, the second contact hole, and the third contact hole partially overlaps the protrusion in the plan view.

11. The display device of claim 9, wherein at least one contact hole among the first contact hole, the second contact hole, and third contact hole is positioned at a center of a pixel electrode adjacent to the at least one contact hole among the first pixel electrode, the second pixel electrode, and the third pixel electrode, optionally wherein the at least one contact hole overlaps the pixel defining layer in the plan view.

12. The display device of any one of claims 9 to 11, further comprising:
a conductive pattern filling each of the first contact hole, the second contact hole, and the third contact hole, contacting each of the first pixel electrode, the second pixel electrode, and the third pixel electrode, and includes a conductive material different from the first pixel electrode, the second pixel electrode, and the third pixel electrode, optionally wherein the first contact hole, the second contact hole, and the third contact hole at least partially overlap the first light emitting layer, the second light emitting layer, and the third light emitting layer in the plan view, respectively.

13. The display device of any one of claims 1 to 12, wherein:
(i) a size of the first pixel electrode is substantially a same as a size of the third pixel electrode; and/or
(ii) each side of the first pixel electrode facing the second pixel electrode is depressed toward a center of the first pixel electrode and each side of the third pixel electrode facing the second pixel electrode is depressed toward a center of the third pixel electrode, and
wherein the second pixel electrode has an octagonal or circular planar shape; and/or
(iii) each side of the third pixel electrode facing the second pixel electrode is depressed toward a center of the third pixel electrode, and
wherein the second pixel electrode has an octagonal or circular planar shape; and/or
(iv) a virtual line extending in a third direction between the first direction and the second direction, and a fourth direction perpendicular to the third direction defines a virtual square, and
wherein centers of first pixel electrodes are positioned at first vertices of the virtual square facing each other, centers of the third pixel electrodes are positioned at second vertices of the virtual square facing each other, and the second pixel electrode is positioned at a center of the virtual square.

14. A display device comprising:
a substrate including a first pixel area, a second pixel area, and a third pixel area which emit light of different colors;
a first light emitting element disposed in the first pixel area on the substrate and including a first pixel electrode having a polygonal planar shape;
a second light emitting element disposed in the second pixel area on the substrate and including a second pixel electrode;
a third emitting element disposed in the third pixel area on the substrate and including a third pixel electrode having a polygonal planar shape; and
a pixel defining layer covering edges of each of the first pixel electrode, the second pixel electrode, and the third pixel electrode and defining a first pixel opening, a second pixel opening, and a third pixel opening exposing at least a part of the first pixel electrode, the second pixel electrode, and the third pixel electrode, respectively,
wherein any one of the first pixel electrode and the third pixel electrode has a quadrangle planar shape including a chamfered corner part.

15. The display device of claim 14, wherein another of the first and third pixel electrodes has a quadrangle or octagonal planar shape, optionally wherein:
(i) a virtual first line extending to coincide with each of first sides extending in a first direction of the any one of the first and third pixel electrodes and a virtual second line extending to coincide with each of second sides extending in a second direction perpendicular to the first direction of the any one of the first and third pixel electrodes define a virtual quadrangle, and
wherein the virtual quadrangle at least partially overlaps the another of the first and third pixel electrode in the plan view; and/or
(ii) when the first pixel electrode includes the chamfered corner part and the third pixel electrode has a quadrangle planar shape, the chamfered corner part of the first pixel electrode surrounds at least a part of corner part of the third pixel electrode facing each other in the plan view.

16. The display device of claim 14 or claim 15, wherein the second pixel electrode has a quadrangle planar shape, optionally wherein:
(i) at least one pixel electrode among the first pixel electrode, the second pixel electrode, and the third pixel electrode includes a protrusion positioned in one side, and
wherein at least one contact hole adjacent to the at least one pixel electrode among the first contact hole, the second contact hole, and the third contact hole partially overlaps the protrusion in the plan view; or
(ii) at least one contact hole among the first contact hole, the second contact hole, and the third contact hole is positioned at a center of a pixel electrode adjacent to the at least one contact hole among the first pixel electrode, the second pixel electrode, and the third pixel electrode.

17. The display device of any one of claims 14 to 16, further comprising:
a first transistor connected to the first pixel electrode through a first contact hole;
a second transistor connected to the second pixel electrode through a second contact hole; and
a third transistor connected to the third pixel electrode through a third contact hole,
optionally wherein at least one contact hole among the first contact hole, the second contact hole, and the third contact hole is positioned at an edge of a pixel electrode adjacent to the at least one contact hole among the first pixel electrode, the second pixel electrode, and the third pixel electrode.
